(19) Europäisches Patentamt
European Patent Office
Office européen des brevets

(11) **EP 3 785 358 B1**

(12) **EUROPÄISCHE PATENTSCHRIFT**

(45) Veröffentlichungstag und Bekanntmachung des Hinweises auf die Patenterteilung:
**29.06.2022 Patentblatt 2022/26**

(21) Anmeldenummer: **19727867.4**

(22) Anmeldetag: **16.05.2019**

(51) Internationale Patentklassifikation (IPC):
*H02M 1/12* (2006.01)   *H02H 7/00* (2006.01)
*H02H 9/00* (2006.01)   *H02J 3/38* (2006.01)
*G01R 27/26* (2006.01)

(52) Gemeinsame Patentklassifikation (CPC):
**H02M 1/126; H02H 7/005; H02H 9/005; H02H 9/007;** G01R 27/2605; **H02J 3/381;** H02J 2300/10

(86) Internationale Anmeldenummer:
**PCT/EP2019/062585**

(87) Internationale Veröffentlichungsnummer:
**WO 2019/242946 (26.12.2019 Gazette 2019/52)**

(54) **ERMITTELN EINER FUNKTION EINES KONDENSATORS EINER PASSIVEN FILTERSCHALTUNG**

DETERMININATION OF A FUNCTION OF A CONDENSER OF A PASSIVE FILTER CIRCUIT

DÉTERMINATION D'UNE FONCTION D'UN CONDENSATEUR D'UN CIRCUIT FILTRANT PASSIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.06.2018 EP 18179098**

(43) Veröffentlichungstag der Anmeldung:
**03.03.2021 Patentblatt 2021/09**

(73) Patentinhaber: **Siemens Aktiengesellschaft 80333 München (DE)**

(72) Erfinder:
• **BENESCH, Norbert 90562 Heroldsberg (DE)**
• **BAUER, Franz 91074 Herzogenaurach (DE)**

(56) Entgegenhaltungen:
**EP-A1- 3 232 217**    **EP-A2- 2 390 997**
**WO-A1-2014/098800**

## Beschreibung

Die Erfindung betrifft ein Verfahren gemäß Anspruch 1 zum Ermitteln einer Funktion eines Kondensators einer passiven Filterschaltung, die leitungsgebundene Störungen einer mit einem Energieversorgungsnetz über die Filterschaltung elektrisch gekoppelten elektrischen Einrichtung zumindest teilweise reduziert, zu welchem Zweck die Filterschaltung wenigstens den einen Kondensator mit einer vorgegebenen Kapazität und wenigstens eine Drosselspule mit einem vorgegebenen Induktivitätswert umfasst, wobei eine elektrische Kondensatorspannung an dem wenigstens einen Kondensator zumindest mittelbar erfasst wird. Die Erfindung betrifft ferner eine Ermittlungseinrichtung gemäß Anspruch 11 zum Ermitteln einer Funktion eines Kondensators einer passiven Filterschaltung, die ausgebildet ist, leitungsgebundene Störungen einer mit einem Energieversorgungsnetz über die Filterschaltung elektrisch gekoppelten elektrischen Einrichtung zumindest teilweise zu reduzieren, zu welchem Zweck die Filterschaltung wenigstens den einen Kondensator mit einer vorgegebenen Kapazität und wenigstens eine Drosselspule mit einem vorgegebenen Induktivitätswert umfasst, wobei die Ermittlungseinrichtung ausgebildet ist, eine elektrische Kondensatorspannung an dem wenigstens einen Kondensator zumindest mittelbar zu erfassen. Schließlich betrifft die Erfindung auch eine elektrische Einrichtung gemäß Anspruch 12 mit einem Anschluss zum elektrischen Koppeln mit einem Energieversorgungsnetz, einer passiven Filterschaltung, die an dem Anschluss angeschlossen ist und über die die elektrische Einrichtung mit dem Energieversorgungsnetz elektrisch koppelbar ist, wobei die passive Filterschaltung ausgebildet ist, leitungsgebundene Störungen zumindest teilweise zu reduzieren, zu welchem Zweck die Filterschaltung wenigstens einen Kondensator mit einem vorgegebenen Kapazitätswert und wenigstens eine Drosselspule mit einem vorgegebenen Induktivitätswert umfasst, und der Ermittlungseinrichtung zum Ermitteln einer Funktion des wenigstens einen Kondensators der passiven Filterschaltung, wobei die Ermittlungseinrichtung ausgebildet ist, eine elektrische Kondensatorspannung an dem wenigstens einen Kondensator zumindest mittelbar zu erfassen.

Der Betrieb von elektrischen Einrichtungen an Energieversorgungsnetzen erfordert, dass Rückwirkungen der elektrischen Einrichtungen auf die Energieversorgungsnetze begrenzt sind, sodass ein bestimmungsgemäßer Betrieb im Verbund gewährleistet werden kann.

Eine elektrische Einrichtung ist insbesondere ein elektrisches Gerät, eine elektrische Antriebseinrichtung, beispielsweise ein elektrischer Wechselrichter, insbesondere ein Netzwechselrichter, ein Energiewandler, beispielsweise ein DC/DC-Wandler, aber auch eine elektrische Maschine, ein Windrad, eine photovoltaische Anlage, ein verbrennungskraftmaschinenbetriebener elektrischer Generator und/oder dergleichen.

Damit der bestimmungsgemäße Betrieb der elektrischen Einrichtung am Energieversorgungsnetz gewährleistet werden kann, sind Anforderungen hinsichtlich der Rückwirkungen auf das Energieversorgungsnetz beziehungsweise in Bezug auf eine elektromagnetische Verträglichkeit einzuhalten. Derartige Anforderungen sind beispielsweise auch gesetzlich oder durch Normung vorgegeben, beispielsweise in der Richtlinie 2014/30/EU über die elektromagnetische Verträglichkeit, dem Gesetz über die elektromagnetische Verträglichkeit von Betriebsmitteln für Deutschland, aber auch durch Normen wie zum Beispiel aus der Reihe EN 61000 und/oder dergleichen.

Die elektromagnetische Verträglichkeit bedeutet dem Grunde nach das Fehlen von Einwirkungen auf andere Geräte und andere elektrische Einrichtungen, die bei diesen zu ungewollten oder auch gewollten Störungen, insbesondere Funkstörungen bei elektrischen oder elektronischen Betriebsmitteln, zum Beispiel aufgrund von elektrischen, magnetischen oder auch elektromagnetischen Feldern und Vorgängen führen. Dies beinhaltet insbesondere auch Beeinflussungen aufgrund von elektrischen Strömen und/oder elektrischen Spannungen.

Insbesondere in Bezug auf leitungsgebundene Störungen, besonders in Bezug auf leitungsgebundene Funkstörungen sind zur Sicherstellung der elektromagnetischen Verträglichkeit ein sachgerechter Aufbau und eine sachgerechte Gestaltung wesentlich. Zu diesem Zweck umfassen elektrische Einrichtungen häufig Filterschaltungen, insbesondere passive Filterschaltungen, mittels denen die Anforderungen hinsichtlich der elektromagnetischen Verträglichkeit, insbesondere in Bezug auf leitungsgebundene Funkstörungen eingehalten werden können. Die Filterschaltungen können auch als separate Baugruppen beziehungsweise Geräte vorgesehen sein, wobei die elektrische Einrichtung dann über die separate Filterschaltung mit dem Energieversorgungsnetz elektrisch gekoppelt ist.

Das Energieversorgungsnetz ist eine Einrichtung, die insbesondere dazu dient, elektrische Energie zwischen daran angeschlossenen elektrischen Einrichtungen zu verteilen. Es kann zum Beispiel auch dazu dienen, lediglich eine einzige elektrische Einrichtung, zum Beispiel einen Energiewandler mit einer elektrischen Energiequelle wie einer elektrischen Maschine, einem elektrischen Energiespeicher, beispielsweise eine Akkumulatoranordnung und/oder dergleichen, elektrisch zu koppeln. Das Energieversorgungsnetz ist vorzugsweise ein öffentliches Energieversorgungsnetz. Es kann jedoch auch ein Inselnetz oder dergleichen sein. Das Energieversorgungsnetz kann aber auch eine oder mehrere elektrische Maschinen umfassen oder zumindest hierdurch gebildet sein. Der Begriff "Energieversorgungsnetz" umfasst daher insbesondere auch eine Anordnung, bei der zum Beispiel eine elektrische Maschine an einem Energiewandler angeschlossen ist, wobei die elektrische Maschine dem Energieversorgungsnetz und der Energiewandler der elektrischen Einrichtung zugeordnet werden kann.

Ein wichtiger Anwendungsbereich betrifft aktive Netzwechselrichter als Energiewandler beziehungsweise als elektrische Einrichtungen. Aktive Netzwechselrichter dienen typischerweise zum Energieaustausch zwischen einem Wechselspannungsnetz und einem Gleichspannungsnetz beziehungsweise einem Gleichspannungszwischenkreis. Das Wechselspannungsnetz kann durch das Energieversorgungsnetz gebildet sein. Aktive Netzwechselrichter sind daher von großer Bedeutung sowohl für Antriebssysteme, in dem zum Beispiel ein Motor-Wechselrichter eine geregelte Gleichspannung des Gleichspannungszwischenkreises als Eingang nutzt, als auch zunehmend für die Energieerzeugung und Energiespeicherung, beispielsweise wenn der Gleichspannungszwischenkreis an eine Batterie, beispielsweise nach Art einer Hochvoltbatterie oder dergleichen angeschlossen ist. Die Batterie ist in der Regel als Akkumulator ausgebildet. Diesbezüglich wird ferner auch auf die Norm IEC TS 62578 verwiesen.

Ein aktiver Netzwechselrichter kann insbesondere dazu ausgebildet sein, einen Energieaustausch zwischen dem Wechselspannungsnetz und dem Gleichspannungszwischenkreis in bidirektionaler Richtung zu ermöglichen. Es ist also möglich, bei einem derartigen aktiven Netzwechselrichter elektrische Energie vom Wechselspannungsnetz beziehungsweise dem Energieversorgungsnetz zum Gleichspannungszwischenkreis sowie auch umgekehrt zu fördern. Dadurch kann beispielsweise eine gleichspannungszwischenkreisseitig vorgesehene Antriebseinrichtung mit elektrischer Energie aus dem Energieversorgungsnetz versorgt werden. Darüber hinaus ist es auch möglich, elektrische Energie, die durch die Antriebseinrichtung am Gleichspannungszwischenkreis bereitgestellt wird, in das Energieversorgungsnetz zu fördern, beispielsweise wenn eine elektrische Maschine der Antriebseinrichtung in einem Generatorbetrieb betrieben wird, zum, um zum Beispiel eine Bremswirkung bereitzustellen, oder auch wenn in der Batterie gespeicherte elektrische Energie oder mittels Fotovoltaik Modulen bereitgestellte elektrische Energie in das Energieversorgungsnetz eingespeist werden soll. Der aktive Netzwechselrichter kann darüber hinaus auch dazu ausgelegt sein, wechselspannungsseitig Blindleistung bereitstellen zu können. Dadurch kann der aktive Netzwechselrichter auch dazu genutzt werden, energieversorgungsnetzseitig beziehungsweise wechselspannungsseitig Blindleistung zumindest teilweise kompensieren zu können.

Elektrische Einrichtungen nutzen Energiewandler wie zum Beispiel Wechselrichter in vielfältigster Form. Heutzutage werden Energiewandler in Form sogenannter statischer Energiewandler eingesetzt, das heißt, dass sie anders als dynamische Energiewandler keine mechanisch bewegbaren, insbesondere keine rotierbaren Teile für den Zweck der Energiewandlung aufweisen. Statische Energiewandler sind in der Regel als getaktete elektrische Energiewandler ausgebildet und weisen zu diesem Zweck wenigstens eine Wandlerinduktivität und wenigstens ein Schaltelement auf, die in geeigneter Weise miteinander verschaltet und zum Beispiel in geeigneter Weise mit dem Energieversorgungsnetz elektrisch gekoppelt sind, sodass durch Betreiben des Schaltelements in einem geeigneten Schaltbetrieb die gewünschte Wandlungsfunktion des Energiewandlers erreicht werden kann.

Ein Schaltelement im Sinne dieser Offenbarung ist dabei vorzugsweise ein steuerbares elektronisches Schaltelement, beispielsweise ein steuerbarer elektronischer Halbleiterschalter wie ein Transistor, ein Thyristor, Kombinationsschaltungen hiervon, vorzugsweise mit parallelgeschalteten Freilaufdioden, ein Gate-Turn-Off-Thyristor (GTO) ein Insulated-Gate-Bipolar-Transistor (IGBT), Kombinationen hiervon oder dergleichen. Dem Grunde nach kann das Schaltelement auch durch einen Feldeffekttransistor, insbesondere einen Metal-Oxide-Semiconductor-Field-Effect-Transistor (MOSFET) gebildet sein.

Zur Bereitstellung der gewünschten Energiewandlungsfunktionalität wird das wenigstens eine Schaltelement im Schaltbetrieb betrieben. In Bezug auf einen Halbleiterschalter nach Art eines Transistors bedeutet dies, dass in einem eingeschalteten Schaltzustand zwischen den eine Schaltstrecke bildenden Anschlüssen des Transistors ein sehr geringer elektrischer Widerstand bereitgestellt wird, sodass ein hoher Stromfluss bei sehr kleiner Restspannung möglich ist. In einem ausgeschalteten Schaltzustand ist hingegen die Schaltstrecke des Transistors hochohmig, das heißt, sie stellt einen hohen elektrischen Widerstand bereit, sodass auch bei hoher, an der Schaltstrecke anliegender elektrischer Spannung im Wesentlichen kein oder nur ein sehr geringer, insbesondere vernachlässigbarer Stromfluss vorliegt. Hiervon unterscheidet sich ein Linearbetrieb bei Transistoren, der aber bei getakteten Energiewandlern in der Regel nicht zum Einsatz kommt.

Das wenigstens eine Schaltelement ist mit einer Steuereinheit gekoppelt. Bei mehreren Schaltelementen für einen Energiewandler sind vorzugsweise sämtliche der mehreren Schaltelemente mit der Steuereinheit gekoppelt. Die Kopplung ist vorzugsweise derart ausgebildet, dass jedes der Schaltelemente individuell gesteuert werden kann. Die Steuereinheit kann als elektronische Schaltung ausgebildet sein, die entsprechende Steuersignale für das wenigstens eine Schaltelement bereitstellt, sodass der gewünschte Schaltbetrieb des Schaltelements realisiert werden kann. Die elektronische Schaltung kann neben elektronischen Bauteilen zur vorgebbaren Bereitstellung der Steuersignale auch wenigstens eine programmgesteuerte Rechnereinheit umfassen, um die gewünschte Funktion der Steuereinheit bereitstellen zu können. Natürlich kann die Steuereinheit auch ausschließlich aus der Rechnereinheit bestehen.

Ist der Energiewandler durch einen aktiven Netzwechselrichter gebildet, kann der aktive Netzwechselrichter zur Realisierung der Energiewandlungsfunktion ein oder mehrere Halbbrückenschaltungen aus Schaltelementen umfassen, die zum Beispiel nach Art einer B6-Brückenschaltung oder dergleichen miteinander verschaltet sein können. Durch Betreiben der Schaltelemente im Schaltbetrieb, bei dem zwei oder auch mehrere unterschiedliche Schaltzustände realisiert sein können, kann über ein Tastverhältnis ein nahezu kontinuierlicher Verlauf einer entsprechenden Spannung, beispielsweise einer Wechselspannung, angenähert werden. Je nach verwendeter Technik und Leistung kann eine Taktrate zwischen einigen 100 Hz bis zu einigen 100 kHz, vorzugsweise typischerweise etwa 2 kHz bis etwa 20 kHz betragen.

Die Wechselspannung eines aktiven Netzwechselrichters kann somit neben einer Grundfrequenz, nämlich zum Beispiel einer Netzfrequenz des Energieversorgungsnetzes sowie gegebenenfalls auch niederfrequenten Netzharmonischen auch spektrale Anteile im Bereich der Taktrate, insbesondere inklusive Seitenbändern, und deren Vielfachen umfassen. Die Grundfrequenz ist dabei vorzugsweise die gewünschte Frequenz, die durch den aktiven Netzwechselrichter bereitgestellt werden soll.

Niederfrequente Netzharmonische können durch eine geeignete Steuerung des Wechselrichters reduziert, wenn nicht sogar ausgeregelt werden. Anders ist dies bei Auswirkungen aufgrund des Schaltbetriebs der Schaltelemente. Die hierdurch hervorgerufenen spektralen Anteile müssen in der Regel durch geeignete schaltungstechnische Maßnahmen, und hier insbesondere passive Filterschaltungen, soweit reduziert werden, dass die Anforderungen an einem Anschlusspunkt der elektrischen Einrichtung am Energieversorgungsnetz eingehalten werden können und andere elektrische Geräte beziehungsweise elektrische Einrichtungen, die ebenfalls am Energieversorgungsnetz angeschlossen sind, möglichst nicht gestört werden. Auf die eingangs genannten Anforderungen, insbesondere in Bezug auf die Normung wird ergänzend hingewiesen.

Eine passive Filterschaltung ist typischerweise aus wenigstens einem Kondensator und wenigstens einer Drosselspule gebildet, die in geeigneter Weise miteinander verschaltet sind. In der Regel ist die wenigstens eine Drosselspule derart geschaltet, dass sie von einem Betriebsstrom der elektrischen Einrichtung im bestimmungsgemäßen Betrieb durchströmt wird. Dagegen ist der wenigstens eine Kondensator in der Regel derart angeschlossen, dass er mit der Betriebsspannung im bestimmungsgemäßen Betrieb beaufschlagt wird.

Für passive Filterschaltungen sind unterschiedliche Schaltungstopologien beziehungsweise Schaltungsstrukturen im Einsatz. In der Regel ist ihnen ein Filterquerzweig mit dem wenigstens einen Kondensator gemeinsam, der nach Art eines Tiefpassfilters beziehungsweise eines Bandpassfilter wirkt und vorzugsweise hochfrequente Störanteile vom Energieversorgungsnetz fernhält. Der wenigstens eine Kondensator bildet also insbesondere für hochfrequente Störanteile, wie sie zum Beispiel durch den Schaltbetrieb der Schaltelemente hervorgerufen werden, eine besonders kleine Impedanz, sodass diese - bildlich ausgedrückt - durch den Filterquerzweig mit dem Kondensator kurzgeschlossen werden. Eine Filterwirkung der Filterschaltung hängt damit unter anderem von einem Kapazitätswert des Kondensators im Filterquerzweig ab.

Der Kapazitätswert des wenigstens einen Kondensators kann sich mit der Zeit ändern, zum Beispiel aufgrund von Alterungserscheinungen, insbesondere wenn der Kondensator durch einen oder mehrere Elektrolytkondensatoren gebildet ist, aufgrund von zumindest zeitweise hohen und/oder niedrigen Temperaturen während des bestimmungsgemäßen Betriebs, aufgrund von Beanspruchung mit einer Überspannung aus dem Energieversorgungsnetz, aufgrund von einer Überlastung durch benachbart angeschlossenen elektrische Einrichtungen, die eine zu hohe, insbesondere unzulässige Störleistung in einem Betriebsbereich der Filterschaltung verursachen können und damit große elektrische Ströme bei dem wenigstens einen Kondensator verursachen können, aufgrund von mechanischen Beschädigungen im Bereich der Filterschaltung sowie auch aufgrund von absichtlicher temporärer Trennung des Filterquerzweigs vom Energieversorgungsnetz, beispielsweise um den Kondensator in bestimmten Betriebssituationen zu schützen. Dies kann insbesondere für Filterschaltungen mit einer LCL-Schaltungsstruktur mit geringer passiver Dämpfung vorgesehen sein, die für einen normgerechten und eigensicheren Betrieb zusätzlich eine aktive Dämpfung, beispielsweise mit Hilfe von geregelten Schalthandlungen des Wechselrichters erfordern können. Ist eine derartige Regelung des Wechselrichters nicht aktiv, kann es erforderlich sein, einen Schutz vor zum Beispiel einer unzulässigen Resonanz der Filterschaltung auf einem anderen Weg zu gewährleisten, zum Beispiel mittels eines Trennschützes und/oder dergleichen.

Um die Funktion des wenigstens einen Kondensators der Filterschaltung ermitteln zu können, ist es im Stand der Technik bisher vorgesehen, neben der Kondensatorspannung zugleich auch einen elektrischen Strom durch den wenigstens einen Kondensator zu erfassen. Unter Nutzung von Berechnungsmethoden der komplexen Wechselstromrechnung kann dann der Kapazitätswert berechnet werden, und zwar gemäß der folgenden Formel:

$$C_F = \frac{|I_F|}{2\pi f_{Netz}|U_F|}$$

Handelt es sich bei dem Energieversorgungsnetz um ein dreiphasiges Wechselspannungsnetz, gilt die vorgenannte Formel für jede Phase des Wechselspannungsnetzes.

In vielen Fällen sind Filterschaltungen sowie auch elektrische Einrichtungen, insbesondere Wechselrichter, separate Geräte, sodass die hierfür erforderliche Strommessung wechselrichterseitig eine externe Messung darstellt. Diese zieht einen hohen Material-, Fertigungs- und Kostenaufwand nach sich. Da die vorgenannte Strommessung, im Unterschied zur Messung der elektrischen Spannung an dem wenigstens einen Kondensator in der Regel nicht für andere Steuerungs- und/oder Regelungszwecke beziehungsweise Überwachungszwecke benötigt wird, entsteht ein ungünstiges Kosten-Nutzen-Verhältnis. Eine derartige Überwachung des wenigstens einen Kondensators der Filterschaltung wird daher im Stand der Technik lediglich als kostenpflichte Zusatzoption angeboten. Im Stand der Technik wird deshalb häufig auch keine derartige Überwachungsfunktion in Anspruch genommen, sodass das Risiko eines Defekts in Bezug auf den wenigstens einen Kondensator mit den entsprechenden Folgeschäden in Kauf genommen wird.

Darüber hinaus ist zu beachten, dass für den speziellen Fall einer Überwachung eines ergänzend im Filterquerzweig angeordneten Trennschalters in der Regel ein Schütz mit einem Rückmeldekontakt genutzt wird. Dadurch sind die Kosten für den Trennschalter hoch. Darüber hinaus führt dies zu einem hohen Aufwand in Bezug auf die Fertigung und die Verdrahtung.

Eine Überwachung von Filterkondensatoren offenbart zum Beispiel die EP 3 232 217 A1. Gemäß dieser Lehre werden Filterkondensatoren mit einem kurzen Impuls geladen und eine hierbei entstehende Schwingung hinsichtlich Spannung oder Strom gemessen. Zu diesem Zweck ist ein Anschluss der Filterschaltung vom Energieversorgungsnetz getrennt. Durch Auswerten der Schwingung kann ein Rückschluss auf einen Zustand der Filterkondensatoren getroffen werden. Diese Lehre ist jedoch nur außerhalb des bestimmungsgemäßen Betriebs der elektrischen Einrichtung nutzbar.

Ferner offenbart die US 9,819,255 B2 eine Möglichkeit, Resonanzen bei Filterschaltungen aktiv zu dämpfen. Zu diesem Zweck wird eine Netzimpedanz ermittelt, indem Impulsfrequenzen verändert werden. Aufgrund der Reaktion der Filterschaltung, beispielsweise indem Resonanzen der Filterschaltung ermittelt werden, kann die Netzimpedanz errechnet und eine Reglerschaltung sowie andere Parameter für die Regelung eingestellt werden. Gegebenenfalls werden nacheinander unterschiedliche elektrische Widerstände zum Dämpfen aktiviert. Eine Überwachung des Zustands der Filterschaltung, insbesondere des wenigstens einen Kondensators ist gemäß dieser Lehre nicht vorgesehen. Bei diesem Verfahren muss die Pulsfrequenz variiert werden. Das kann jedoch erhöhte beziehungsweise unzulässige Netzrückwirkungen und insbesondere auch erhöhte Schaltverluste verursachen. Dies kann neben den erhöhten beziehungsweise unzulässigen Netzrückwirkungen somit auch zu einer erhöhten thermischen Beanspruchung des Wechselrichters führen. Ferner ist zu beachten, dass ein etwaiges, insbesondere selektives Zuschalten wenigstens eines Dämpfungswiderstands einen zusätzlichen hohen Aufwand bedeuten kann. Insgesamt ist es wünschenswert, die Funktion des wenigstens einen Kondensators zu ermitteln, damit das Einhalten von Anforderungen hinsichtlich der elektromagnetischen Verträglichkeit, insbesondere in Bezug auf leitungsgebundene Störungen dauerhaft gewährleistet werden kann. Ist zudem ein Trennschalter im Filterquerzweig vorgesehen, mittels dem der wenigstens eine Kondensator aktiviert beziehungsweise deaktiviert werden kann, kann zugleich auch eine Überwachung der Funktionalität des Trennschalters gewünscht sein. Dabei sollte der erforderliche Aufwand möglichst gering sein.

Es ist deshalb die Aufgabe der Erfindung, das Ermitteln der Funktion des wenigstens einen Kondensators der Filterschaltung weitgehend mit vorhandenen Funktionalitäten der elektrischen Einrichtung zu realisieren und dadurch zusätzlichen Aufwand möglichst weitgehend zu vermeiden.

Als Lösung werden mit der Erfindung ein Verfahren, eine Ermittlungseinrichtung sowie eine elektrische Einrichtung gemäß den unabhängigen Ansprüchen vorgeschlagen.

Vorteilhafte Weiterbildungen ergeben sich durch Merkmale der abhängigen Ansprüche.

Bezüglich des erfindungsgemäßen Verfahrens wird vorgeschlagen, dass eine Anschlussspannung der elektrischen Einrichtung erfasst wird, für die Kondensatorspannung und die Anschlussspannung jeweilige spektrale Komponenten ermittelt werden, und die Funktion des wenigstens einen Kondensators ermittelt wird, indem die spektralen Komponenten bezüglich der Kondensatorspannung und der Anschlussspannung unter Berücksichtigung des Induktivitätswerts der wenigstens einen Drosselspule mittels wenigstens einer statistischen Verarbeitung ausgewertet werden, indem eine frequenzabhängige Dämpfung der passiven Filterschaltung ermittelt wird, aus der ein Schätzwert für einen Kapazitätswert des wenigstens einen Kondensators berechnet wird, um aus dem Schätzwert die Funktion des wenigstens einen Kondensators abzuleiten, wobei die frequenzabhängige Dämpfung als Filterdämpfung der passiven Filterschaltung oberhalb einer Grenzfrequenz im Wesentlichen von der Impedanz des wenigstens einen Kondensators abhängt, und die frequenzabhängige Dämpfung in Abhängigkeit eines Verhältnisses der spektralen Komponente der Kondensatorspannung zur spektralen Komponente der Anschlussspannung ermittelt wird.

Bezüglich der erfindungsgemäßen Ermittlungseinrichtung wird vorgeschlagen, dass die Ermittlungseinrichtung ausgebildet ist, eine Anschlussspannung der elektrischen Einrichtung zu erfassen, für die Kondensatorspannung und die Anschlussspannung jeweilige spektrale Komponenten zu ermitteln, und die Funktion des wenigstens einen Kondensators zu ermitteln, indem die Ermittlungseinrichtung dazu eingerichtet ist, die spektralen Komponenten bezüglich der Kondensatorspannung und der Anschlussspannung unter Berücksichtigung des Induktivitätswerts der wenigstens einem Drosselspule mittels wenigstens einer statistischen Verarbeitung auszuwerten, zu welchem Zweck die Ermittlungseinrichtung dazu eingerichtet ist, eine frequenzabhängige Dämpfung der passiven Filterschaltung zu ermitteln, daraus einen Schätzwert für einen Kapazitätswert des wenigstens einen Kondensators zu berechnen, und aus dem Schätzwert die Funktion des wenigstens einen Kondensators abzuleiten, wobei die frequenzabhängige Dämpfung als Filterdämpfung der passiven Filterschaltung oberhalb einer Grenzfrequenz im Wesentlichen von der Impedanz des wenigstens einen Kondensators abhängt, und die Ermittlungseinrichtung dazu eingerichtet ist, die frequenzabhängige Dämpfung in Abhängigkeit eines Verhältnisses der spektralen Komponente der Kondensatorspannung zur spektralen Komponente der Anschlussspannung zu ermitteln.

Bezüglich der erfindungsgemäßen elektrischen Einrichtung wird vorgeschlagen, dass diese eine Ermittlungseinrichtung gemäß der Erfindung umfasst.

Die Erfindung basiert auf der Erkenntnis, dass die Filterwirkung der passiven Filterschaltung in einem spektralen Bereich oberhalb einer Taktrate im bestimmungsgemäßen Betrieb der elektrischen Einrichtung im Wesentlichen von dem wenigstens einen Kondensator der passiven Filterschaltung abhängig ist, und zwar in einem weiten Bereich nahezu unabhängig davon, ob und welche elektrischen Einrichtungen ergänzend an das Energieversorgungsnetz angeschlossen sind. Dies erlaubt es, anhand von spektralen Komponenten der Kondensatorspannung und der Anschlussspannung und unter Nutzung von des Induktivitätswerts der wenigstens einen Drosselspule sowie wenigstens einer statistischen Verarbeitung die Funktion des Kondensators zu ermitteln, zumindest mit einer vorgebbaren Zuverlässigkeit zu schätzen. Dadurch braucht - im Unterschied zum Stand der Technik - ein elektrischer Strom durch den wenigstens einen Kondensator der passiven Filterschaltung nicht mehr erfasst zu werden. Anders als beim Stand der Technik braucht die Erfindung also keinen teuren und aufwändigen Stromsensor, um die Funktion des wenigstens einen Kondensators der Filterschaltung ermitteln zu können.

Dadurch kann die Erfindung nicht nur besonders einfach und kostengünstig realisiert werden, sondern sie eignet sich deshalb insbesondere auch für die Nachrüstung bei bereits bestehenden elektrischen Einrichtungen. So können insbesondere auch elektrische Einrichtungen mit dieser Funktionalität gemäß der Erfindung nachträglich ausgerüstet werden, bei denen aus Kostengründen auf eine entsprechende Funktionalität bislang verzichtet worden ist. Insgesamt erlaubt es die Erfindung, mit geringem Aufwand die Zuverlässigkeit und die Sicherheit im bestimmungsgemäßen Betrieb der elektrischen Einrichtung am Energieversorgungsnetz deutlich zu verbessern.

Auch wenn sich die Erfindung insbesondere auf passive Filterschaltungen mit einer LCL-Schaltungsstruktur gerichtet ist, ist sie jedoch auf diese nicht beschränkt. Die Schaltungsstruktur der passiven Filterschaltung kann natürlich auch nahezu beliebig abgewandelt werden, um eine gewünschte Filterfunktionalität realisieren zu können, wobei die Anwendung der Erfindung weiterhin weitgehend ermöglicht ist.

Die Kondensatorspannung sowie auch die Anschlussspannung können mittels einer oder mehrere geeigneter Spannungssensoreinheiten erfasst werden. Die Spannungssensoreinheiten können an die Steuereinheit angeschlossen sein und gegebenenfalls sogar von dieser umfasst sein. Darüber hinaus können natürlich auch Spannungssensoreinheiten genutzt werden, die ohnedies bereits bei der elektrischen Einrichtung für deren bestimmungsgemäßen Betrieb vorgesehen sind. In diesem Fall brauchen dann keine separaten Spannungssensoreinheiten für die Spannungserfassung vorgesehen zu sein. Natürlich können hiervon auch Kombinationen vorgesehen sein.

Umfasst die elektrische Einrichtung beispielsweise einen Netzwechselrichter kann die Anschlussspannung diejenige Spannung sein, die der Netzwechselrichter energieversorgungsnetzseitig bereitstellt. Vorzugsweise handelt es sich um diejenige elektrische Spannung, die an der Filterschaltung einrichtungsseitig anliegt.

Die Kondensatorspannung und die Anschlussspannung werden dann dahingehend behandelt, dass zunächst jeweilige spektrale Komponenten ermittelt werden. Das Ermitteln der jeweiligen spektralen Komponenten kann mittels einer geeigneten mathematischen Transformation oder dergleichen durchgeführt werden, beispielsweise einer Fourier-Transformation, einer Laplace-Transformation, Derivaten hiervon und/oder dergleichen.

Die hierdurch ermittelten spektralen Komponenten bezüglich der Kondensatorspannung und der Anschlussspannung werden dann unter Berücksichtigung des Induktivitätswerts der wenigstens einen Drosselspule mittels wenigstens einer statistischen Verarbeitung ausgewertet. Zu diesem Zweck kann vorgesehen sein, dass die Induktivität der wenigstens eine Drosselspule entweder für die Auswertung vorgegeben wird, indem ein gemessener Induktivitätswert der Drosselspule zur Verfügung gestellt wird, oder der Induktivitätswert der Drosselspule wird auf andere geeignete Weise ermittelt, beispielsweise in dem mittels Sensoren geeignete elektrische Größen erfasst werden, aus denen der Induktivitätswert der Drosselspule ermittelt werden kann, oder dergleichen.

Aus den spektralen Komponenten und dem Induktivitätswert der wenigstens einen Drosselspule kann dann eine frequenzabhängige Dämpfung der passiven Filterschaltung ermittelt werden, die es erlaubt, einen Schätzwert für einen Kapazitätswert des wenigstens einen Kondensators zu berechnen. Aus dem Schätzwert kann dann die Funktion des wenigstens einen Kondensators abgeleitet werden. Die hierdurch ermittelte Funktion des wenigstens einen Kondensators kann dann beispielsweise einer Filterüberwachungseinheit mit einer Benutzungswarnung und/oder Fehlerabschaltung zur Verfügung gestellt werden. Die Benutzungswarnung kann zum Beispiel eine Ausgabe sein, die ein Signal ausgibt, wenn die Funktion des wenigstens einen Kondensators für den bestimmungsgemäßen Betrieb der passiven Filterschaltung nicht weiter gewährleistet ist. Entsprechend kann auch eine Fehlerabschaltung vorgesehen sein, die es ermöglicht, die elektrische Einrichtung bei Vorliegen eines entsprechenden Signals zu deaktivieren.

Die Erfindung nutzt aus, dass durch die Schaltungsstruktur der passiven Filterschaltung die Filterdämpfung oberhalb einer Grenzfrequenz im Wesentlichen von der Impedanz im Filterquerzweig und damit von dem wenigstens einen Kondensator abhängt. Diese Eigenschaft ermöglicht eine ausreichend genaue Schätzung des Kapazitätswerts des wenigstens einen Kondensators, ohne dass eine entsprechende Strommessung erforderlich wäre. Dies ist möglich, obwohl am Energieversorgungsnetz weitere elektrische Einrichtungen unbekannter Art und gegebenenfalls auch mit stark veränderlichen Netzeigenschaften angeschlossen sein können.

Gemäß einer vorteilhaften Weiterbildung wird vorgeschlagen, dass der wenigstens eine Kondensator an einen seiner Anschlüsse mit einem elektrischen Bezugspotential und an einem anderen seiner Anschlüsse mit einem elektrischen Phasenpotential beaufschlagt wird. Diese Weiterbildung ist insbesondere darauf gerichtet, dass das Energieversorgungsnetz ein Wechselspannungsnetz ist. Ist das Energieversorgungsnetz ein mehrphasiges Wechselspannungsnetz, kann eine entsprechende passive Filterschaltung für jede Phase des mehrphasigen Wechselspannungsnetzes vorgesehen sein. Besonders vorteilhaft kann vorgesehen sein, dass ein dreiphasiges Wechselspannungsnetz vorgesehen ist, wobei die jeweiligen wenigstens einen Kondensatoren der jeweiligen Filterschaltungen mit einem ihrer Anschlüsse miteinander elektrisch verbunden sind und dadurch das elektrische Bezugspotential bilden können. Durch diese Ausgestaltung kann die gewünschte Funktion gemäß der Erfindung auch auf besonders einfache Weise bei dreiphasigen Wechselspannungsnetzen als Energieversorgungsnetzen realisiert werden.

Weiterhin wird vorgeschlagen, dass die Anschlussspannung und/oder die Kondensatorspannung diskretisiert erfasst werden und das Auswerten digital erfolgt. Diskretisiertes Erfassen meint vorliegend, dass die jeweilige der Spannungen vorzugsweise sowohl wertediskret als auch zeitdiskret erfasst wird. Dadurch eröffnet sich die Möglichkeit, die entsprechend erfassten jeweiligen Spannungen der digitalen Signalverarbeitung zuzuführen. Dadurch kann eine verbesserte Realisierung der Erfindung erreicht werden. Insbesondere erlaubt es diese Ausgestaltung, die Erfindung auch bei vorhandenen elektrischen Einrichtungen auf einfache Weise nachzurüsten, bei denen bereits eine digitale Signalverarbeitung vorhanden ist. Das zeitdiskrete Erfassen der jeweiligen Spannung kann vorsehen, dass die zu erfassende elektrische Spannung zu vorgebbaren, vorzugsweise äquidistanten Zeitpunkten abgetastet wird. Dabei ist eine jeweilige Abtastrate vorzugsweise mindestens doppelt so groß wie die größte Frequenz der abzutastenden jeweiligen Spannung. Die auf diese Weise diskretisierten jeweiligen Spannungen können dann einer digitalen Signalverarbeitung zugeführt werden, indem beispielsweise eine digitale Transformation bezüglich des Ermittelns jeweiliger spektraler Komponenten angewendet wird.

Vorzugweise umfasst das Auswerten ein Ermitteln eines Kapazitätswerts des wenigstens einen Kondensator. Dies erlaubt es, auch graduelle Veränderungen der passiven Filterschaltung über eine Betriebsdauer ermitteln zu können, die durch den wenigstens einen Kondensator bestimmt sind. Dadurch ist es möglich, die passive Filterschaltung genauer hinsichtlich ihrer bestimmungsgemäßen Funktion überwachen zu können. Diese Weiterbildung richtet sich also insbesondere auch darauf, dass die passive Filterschaltung einer Alterung während des bestimmungsgemäßen Betriebs unterliegen kann, die dazu führen kann, dass die gewünschte Filterwirkung mit zunehmender Betriebsdauer abnimmt. Das Ermitteln des Kapazitätswerts des wenigstens einen Kondensators erlaubt es dann, zu prüfen, ob die Filterschaltung im bestimmungsgemäßen aktuellen Betrieb noch eine ausreichende Filterwirkung bereitstellt.

Wird zum Beispiel ermittelt, dass der Kapazitätswert soweit reduziert ist, dass die Filterschaltung die bestimmungsgemäße Filterwirkung gerade noch oder gerade nicht mehr bereitzustellen vermag, kann zum Beispiel ein Wartungssignal ausgelöst werden. Es kann aber auch ein Deaktivierungssignal ausgelöst werden, mittels welchem die elektrische Einrichtung dann deaktiviert wird. Durch eine Wartung, das heißt, beispielsweise einen Austausch des wenigstens einen Kondensators, kann die Filterschaltung dann wieder in ihre bestimmungsgemäße Funktion zurückgesetzt werden, sodass der Betrieb der elektrischen Einrichtung wieder aufgenommen werden kann. Dies kann zum Beispiel dadurch erfolgen, dass mittels der Ermittlungseinrichtung ermittelt wird, dass die gewartete passive Filterschaltung wieder einen ausreichenden Kapazitätswert in Bezug auf den wenigstens einen Kondensator bereitstellt und somit die bestimmungsgemäße Filterwirkung im bestimmungsgemäßen Betrieb bereitzustellen vermag. Ein entsprechendes Aktivierungssignal für die elektrische Einrichtung kann dann bereitgestellt werden, sodass sogar eine automatische Freigabe generiert werden kann.

Darüber hinaus wird vorgeschlagen, dass Auswerten ein Vergleichen des ermittelten Kapazitätswerts mit einem Kapazitätsvergleichswert umfasst. Dadurch kann während des bestimmungsgemäßen Betriebs der passiven Filterschaltung erreicht werden, dass diese nahezu kontinuierlich während des bestimmungsgemäßen Betriebs überwacht werden kann oder auch zu vorgebbaren Zeitpunkten, wobei durch Vergleich des ermittelten Kapazitätswerts mit dem Kapazitätsvergleichswert ermittelt werden kann, ob der Kapazitätswert des wenigstens einen Kondensators, der aktuell ermittelt worden ist, ausreicht, um die bestimmungsgemäße Funktion der Filterschaltung realisieren zu können.

Es wird weiterhin vorgeschlagen, dass zum Auswerten nur ein Teil der spektralen Komponenten oberhalb einer durch die Filterschaltung bestimmten Grenzfrequenz berücksichtigt wird. Dadurch kann der Aufwand für das Auswerten reduziert werden, insbesondere basierend auf der Erkenntnis, dass die Auswirkungen des wenigstens einen Kondensators in Bezug auf die Filtereigenschaften in der Regel besonders deutlich oberhalb der Grenzfrequenz der passiven Filterschaltung auftreten. Dies berücksichtigt, dass die passive Filterschaltung in der Regel eine Tiefpass- und/oder eine Bandpasswirkung bereitstellt. Die Auswirkungen von Veränderungen in Bezug auf den Kapazitätswert des wenigstens einen Kondensators können deshalb in einem Bereich oberhalb der Grenzfrequenz besonders gut ermittelt werden.

Gemäß einer Weiterbildung wird vorgeschlagen, dass ein Schaltzustand eines in Reihe zum wenigstens einen Kondensator geschalteten Schaltelements ermittelt wird. Das wenigstens einen Schaltelement kann - wie eingangs bereits erwähnt - dazu dienen, den wenigstens einen Kondensator der passiven Filterschaltung zu aktivieren oder auch zu deaktivieren, und zwar abhängig von einem jeweiligen Belastungszustand der passiven Filterschaltung. Das Schaltelement ist häufig durch ein elektromechanisches Schaltelement gebildet, beispielsweise durch einen Trennschalter nach Art eines Relais, eines Schützes oder dergleichen. Es kann jedoch auch durch ein elektronisches Schaltelement gebildet sein, beispielsweise einem Transistor oder dergleichen, der in einem Schaltbetrieb betrieben wird. Das Schaltelement kann jedoch hinsichtlich des bestimmungsgemäßen Betriebs auch gestört sein, sodass insbesondere wenn der wenigstens eine Kondensator aktiviert sein soll, ein Defekt des Schaltelements dazu führen kann, dass der wenigstens eine Kondensator trotzdem nicht aktiviert ist. Dies kann ebenfalls mit der Erfindung auf gleiche Weise ermittelt werden. Es ist also nicht erforderlich, zusätzliche spezielle Hardware vorzusehen, die eine Überwachung der Schaltfunktion des Schaltelements ermöglichen würde. Vielmehr kann die Erfindung die Funktionalität des Schaltelements ebenfalls zugleich mit überprüfen.

Besonders vorteilhaft erweist es sich, wenn das Verfahren bei einer elektrischen Einrichtung angewendet wird, die einen Wechselrichter umfasst. Da in der Regel der Wechselrichter bereits eine zumindest teilweise digitalisierte Steuerung umfasst, kann bei einer solchen elektrischen Einrichtung die Erfindung auch auf einfache Weise nachgerüstet werden beziehungsweise ergänzend implementiert werden. Besonders vorteilhaft erweist sich der Einsatz der Erfindung bei aktiven Netzwechselrichtern.

Weiterhin kann die Erfindung besonders vorteilhaft bei einer Filterschaltung angewendet werden, die eine LCL-Schaltungsstruktur umfasst. Die Erfindung ist allerdings nicht auf eine derartige Schaltungsstruktur begrenzt. Weiterhin wird vorgeschlagen, dass das Auswerten ein Anti-Aliasing-Filtern umfasst. Durch das Anti-Aliasing-Filtern kann erreicht werden, dass insbesondere bei einer zumindest teilweise digitalen Signalverarbeitung beziehungsweise einem zumindest teilweise digitalen Auswerten Störungen beispielsweise aufgrund von Durchführung von Transformationen reduziert wenn nicht sogar vollständig vermieden werden können. Bezüglich Aliasing wird zum Beispiel verwiesen auf die Literatur Steinbuch, Rupprecht, Nachrichtentechnik, 3. Auflage, Band 2, Springer-Verlag 1982 oder dergleichen.

Die für das erfindungsgemäße Verfahren angegebenen Vorteile und Wirkungen gelten natürlich gleichermaßen auch für die erfindungsgemäße Ermittlungseinrichtung sowie die erfindungsgemäße elektrische Einrichtung und umgekehrt. Infolgedessen können natürlich für Verfahrensmerkmale auch Vorrichtungsmerkmale und umgekehrt formuliert sein.

Weitere Vorteile und Merkmale ergeben sich durch die folgenden Ausführungsbeispiele anhand der beigefügten Figuren. In den Figuren bezeichnen gleiche Bezugszeichen gleiche Merkmale und Funktionen.

Es zeigen:

FIG 1: eine schematische Blockschaltbilddarstellung eines über eine passive Filterschaltung an ein dreiphasiges Wechselspannungsnetz angeschlossenen Netzwechselrichters;

FIG 2: eine schematische Schaltbilddarstellung für eine erste Ausgestaltung einer passiven Filterschaltung nach Art eines LCL-Filters;

FIG 3: eine schematische Schaltbilddarstellung für eine zweite Ausgestaltung einer passiven Filterschaltung nach Art eines verdrosselten LCL-Filters mit Dämpfung;

FIG 4: eine schematische Schaltbilddarstellung für eine dritte Ausgestaltung einer passiven Filterschaltung nach Art eines LZ-Filters mit Dämpfung;

FIG 5: eine schematische Diagrammdarstellung zur Darstellung einer Filterdämpfung für die passive Filterschaltung gemäß FIG 2;

FIG 6: eine schematische Blockschaltbilddarstellung wie FIG 1 jedoch mit einer Ermittlungseinrichtung gemäß der Erfindung;

FIG 7: eine schematische Diagrammdarstellung einer spektralen Analyse einer Anschlussspannung des Wechselrichters gemäß FIG 1 ohne passive Filterschaltung;

FIG 8: eine schematische Ersatzschaltbilddarstellung eines Systems umfassend den Wechselrichter gemäß FIG 1, das LCL-Filter gemäß FIG 2 sowie schematisch dargestellte Größen des Energieversorgungsnetzes für eine von drei Phasen des Wechselspannungsnetzes;

FIG 9-13: schematische Diagrammdarstellungen wie FIG 5 für unterschiedliche Auslegungen beziehungsweise Betriebszustände des LCL-Filters gemäß FIG 2.

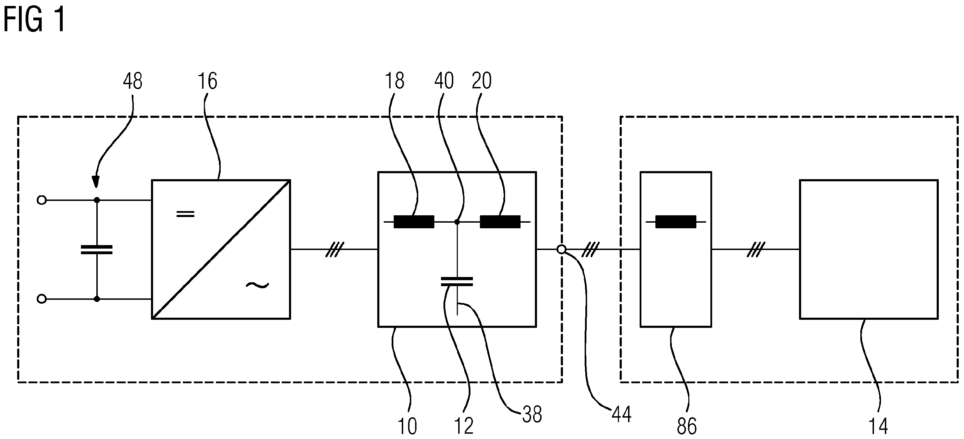

FIG 1 zeigt in einer Blockschaltbilddarstellung eine elektrische Einrichtung, die vorliegend einen aktiven Netzwechselrichter 16 aufweist, der über ein LCL-Filter 10 als passive Filterschaltung mit einem dreiphasigen Wechselspannungsnetz 14 als Energieversorgungsnetz elektrisch gekoppelt ist. Der Netzwechselrichter 16 dient zum elektrischen Koppeln des Wechselspannungsnetzes 14 mit einem Gleichspannungszwischenkreis 48.

Der Netzwechselrichter 16 ist für eine bidirektionale Energiekopplung zwischen dem Gleichspannungszwischenkreis 48 und dem Wechselspannungsnetz 14 ausgebildet. Zu diesem Zweck umfasst der Netzwechselrichter 16 nicht weiter dargestellte Halbbrückenschaltungen mit Schaltelementen, die vorliegend durch Transistoren gebildet sind, die mittels einer ebenfalls nicht dargestellten Steuereinheit in einem Schaltbetrieb in geeigneter Weise betrieben werden.

Wechselspannungsseitig ist der Netzwechselrichter 16 über das LCL-Filter 10 mit dem Wechselspannungsnetz 14 elektrisch gekoppelt. Für jede Phase der dreiphasigen Wechselspannung des Wechselspannungsnetzes 14 ist ein jeweiliger Zweig des LCL-Filters 10 vorgesehen, der jeweils zwei in Serie geschaltete Drosselspulen 18, 20 sowie in einem Filterquerzweig einen Kondensator 12 umfasst. Der Kondensator 12 ist mit einem seiner Anschlüsse mit einem elektrischen Bezugspotential 38 elektrisch gekoppelt, welches für sämtliche Phasen gleich ist, und mit einem zweiten Anschluss mit einem entsprechenden Phasenpotential 40, welches für jede Phase des Wechselspannungsnetzes 14 individuell ist. Der Netzwechselrichter 16 ist zusammen mit dem LCL-Filter 10 über einen elektrischen Anschluss 44 mit dem Energieversorgungsnetz 14 elektrisch gekoppelt.

Das LCL-Filter 10 ist ausgebildet, leitungsgebundene Störungen zumindest teilweise zu reduzieren, zu welchem Zweck das LCL-Filter 10 den Kondensator 12 mit einem vorgegebenen Kapazitätswert und in dieser Ausgestaltung zwei Drosselspulen 18, 20 mit jeweiligen vorgegebenen Induktivitätswerten umfasst.

In FIG 1 ist bezüglich des Wechselspannungsnetzes 14 eine Netzinduktivität 86 als separates Element für eine jeweilige Phase des Wechselspannungsnetzes 14 dargestellt. Sie ist in der Realität im Wesentlichen durch Leitungsinduktivitäten des Wechselspannungsnetzes 14 bestimmt.

Die Schaltelemente des Netzwechselrichters 16 werden vorliegend im Schaltbetrieb mit einer Taktrate in einem Bereich von etwa 4 kHz betrieben. Die Taktrate kann jedoch auch zwischen einigen 100 Hz bis zu einigen 100 kHz, vorzugsweise zwischen etwa 2 kHz bis etwa 20 kHz, gewählt sein. Sie braucht nicht konstant zu sein.

Damit am Anschluss 44 Anforderungen hinsichtlich der elektromagnetischen Verträglichkeit, insbesondere in Bezug auf leitungsgebundene Störungen, eingehalten werden können, ist das LCL-Filter 10 vorgesehen. Durch geeignete Dimensionierung der Drosselspulen 18, 20 und des Kondensators 12 kann erreicht werden, dass die vorgegebenen Anforderungen am Anschluss 44 eingehalten werden können.

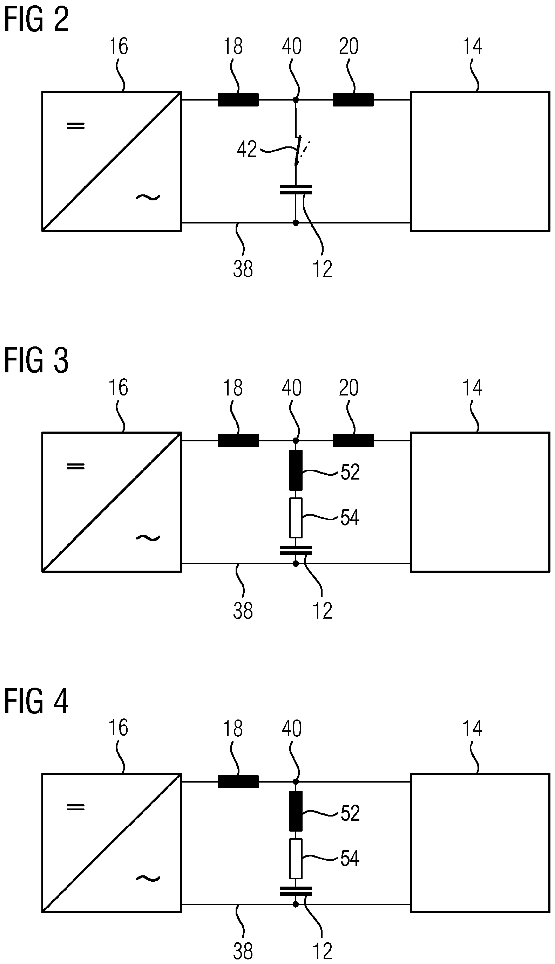

Die FIG 2 bis 4 zeigen unterschiedliche mögliche Ausgestaltungen für die passive Filterschaltung, wie sie für die Ausgestaltung gemäß FIG 1 zum Einsatz kommen können. Diese Schaltungsstrukturen sind jedoch nicht abschließend und zeigen lediglich einige mögliche alternative Ausführungsbeispiele, die natürlich auch hinsichtlich der Schaltungsstruktur noch untereinander nahezu beliebig kombiniert werden können.

FIG 2 zeigt ein typisches LCL-Filter 10 mit den beiden Drosselspulen 18, 20 und dem Kondensator 12, wobei in Reihe zum Kondensator 12 vorliegend auch noch ein Schütz 42 geschaltet ist, mittels welchem der Kondensator 12 abhängig von einem jeweiligen Schaltzustand des Schützes 42 aktivierbar beziehungsweise deaktivierbar ist.

FIG 3 zeigt eine alternative Ausgestaltung zur Schaltungsstruktur gemäß FIG 2, die jedoch auf der Schaltungsstruktur gemäß FIG 2 basiert. Im Unterschied zur Ausgestaltung gemäß FIG 2 ist bei der Ausgestaltung gemäß FIG 3 anstelle des Schützes 42 in FIG 2 nunmehr eine Reihenschaltung aus einer weiteren Drosselspule 52 und einem elektrischen Widerstand 54 vorgesehen. Es handelt sich hierbei um ein verdrosseltes LCL-Filter mit Dämpfung.

FIG 4 zeigt eine Abwandlung der Ausgestaltung gemäß FIG 3, bei der anstelle der Drosselspule 20 ein Kurzschluss vorgesehen ist. Dadurch wird ein LZ-Filter mit Dämpfung gebildet.

Die vorgenannten Filterschaltungen können natürlich auch miteinander kombiniert werden, um zu weiteren passiven Filterschaltungen im Rahmen der Erfindung gelangen zu können. Natürlich kann auch vorgesehen sein, dass eine jeweilige passive Filterschaltung mehr als lediglich einen einzigen Kondensator 12 umfasst. Es können auch mehrere Kondensatoren 12 vorgesehen sein, die zumindest teilweise auch parallelgeschaltet sein können.

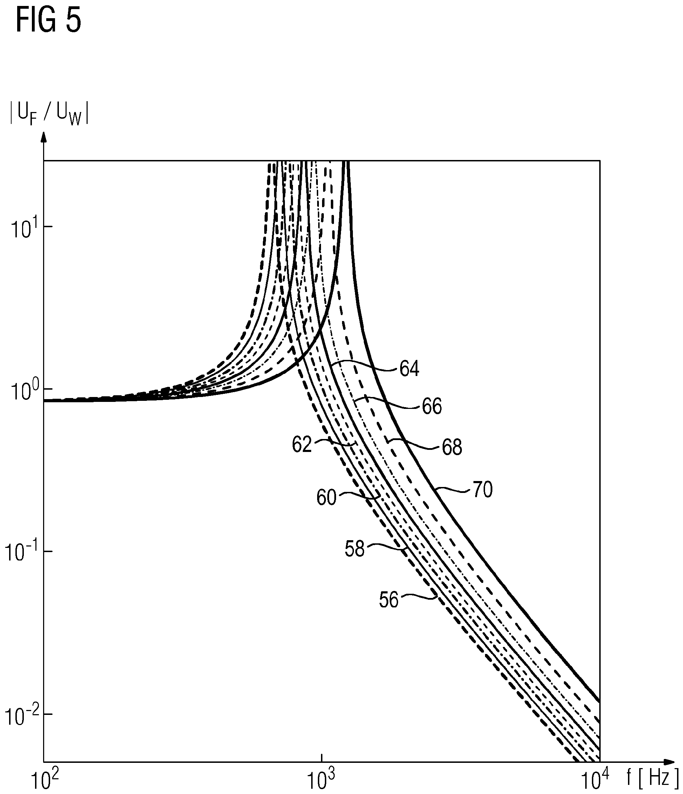

FIG 5 zeigt eine schematische Diagrammdarstellung zur Verdeutlichung der Filterdämpfung des LCL-Filters 10 gemäß FIG 1 beziehungsweise 2, wenn das Schütz 42 im eingeschalteten Schaltzustand ist. Die Abszisse des Diagramms gemäß FIG 5 ist einer Frequenz in Hertz zugeordnet. Eine Ordinate des Diagramms gemäß FIG 5 ist einem Verhältnis von spektralen Komponenten 26, 28 zugeordnet. Diese werden, wie im Folgenden noch erläutert werden wird, aus mittels einer Spannungssensoreinheit 36 erfassten elektrischen Spannungen, und zwar einer Ausgangsspannung 22 des Netzwechselrichters 16 sowie einer Kondensatorspannung 24 des Kondensators 12 entsprechend ermittelt. Für die Zwecke dieser Darstellung wird angenommen, dass ein sehr kleiner Dämpfungswiderstand im Bereich von 1 mQ vorliegt. Ein netzseitiger Induktivitätswert beträgt etwa 30 µH. Ein Induktivitätswert der Drosselspulen 18, 20 beträgt vorliegend etwa 300 µH. Mittels der Graphen 56 bis 70 sind die Filterwirkungen bei unterschiedlichen Kapazitätswerten für den Kondensator 12 dargestellt. Der Graph 56 kann dabei einem Kapazitätswert von 1 mF zugeordnet werden. Der Graph 58 ist einem Kapazitätswert von 900 µF zugeordnet. Der Graph 60 ist einem Kapazitätswert von 800 µF zugeordnet. Der Graph 62 ist einem Kapazitätswert von 700 µF zugeordnet. Der Graph 64 ist einem Kapazitätswert von 600 µF zugeordnet, der Graph 66 ist einem Kapazitätswert von 500 µF zugeordnet, der Graph 68 ist einem Kapazitätswert von 400 µF zugeordnet und der Graph 70 ist einem Kapazitätswert von 300 µF zugeordnet.

Das LCL-Filter 10 ist dabei typischerweise derart dimensioniert, dass spektrale Anteile aufgrund des Taktbetriebs des Netzwechselrichters 16 oberhalb einer Filterresonanzfrequenz in einem Bereich der Taktrate von vorliegend zum Beispiel etwa 5 kHz reduziert werden, sodass am Anschluss 44 im Wesentlichen nur noch normgerechte kleine spektrale Anteile erfassbar sind. Wie aus FIG 5 ersichtlich ist, würde eine Halbierung des Kapazitätswerts des Kondensators 12 zu einer Verdopplung der Netzrückwirkungen führen und damit eine Störung oder einer Beschädigung benachbarter elektrischer Einrichtungen zur Folge haben können.

Die Erfindung ermöglicht es demnach, einen Kapazitätswert des Kondensators 12 und damit das Einhalten der Anforderungen für die Netzrückwirkungen dauerhaft zu gewährleisten. Bei ergänzender Anordnung des Schützes 42 in Reihe zum Kondensator 12 kann ergänzend insbesondere gleichzeitig erreicht werden, dass auch eine Schließerfunktion des Schützes 42 überwacht wird.

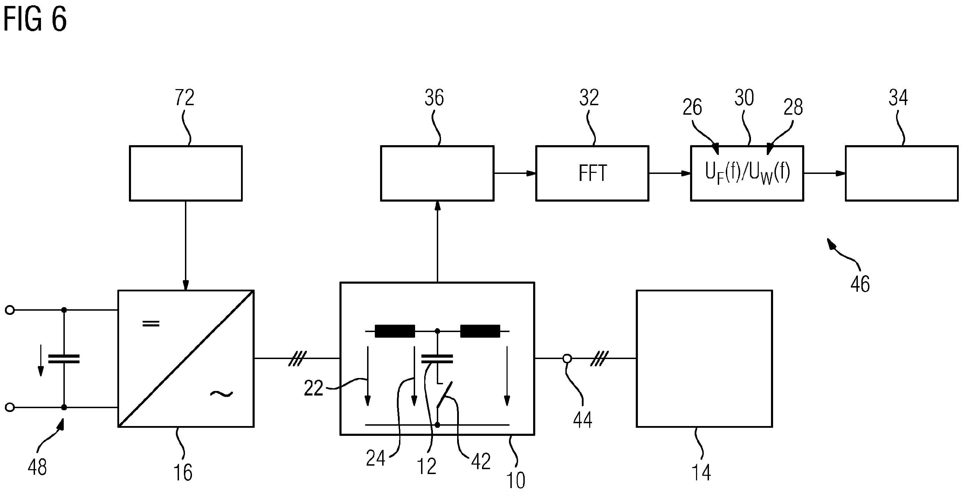

FIG 6 zeigt nun basierend auf FIG 1 eine Ergänzung im Rahmen der Erfindung, mittels der ein Überwachen des Kondensators 12 des LCL-Filters 10 erreicht werden kann, ohne dass eine Strommessung ergänzend vorgesehen zu werden braucht. Zu diesem Zweck wird, wie aus FIG 6 ersichtlich ist, neben einer Anschlussspannung 22, die unmittelbar durch den Netzwechselrichter 16 wechselspannungsseitig bereitgestellt wird, auch eine Kondensatorspannung 24 am Kondensator 12 erfasst. Dies erfolgt mittels der Spannungssensoreinheit 36, die diese Spannungen jeweils digitalisiert erfasst. Auch wenn vorliegend eine digitale Signalverarbeitung vorgesehen ist, kann dem Grunde nach die Funktion der Erfindung natürlich auch zumindest teilweise analog realisiert sein.

Aus FIG 6 ist ersichtlich, dass der Netzwechselrichter 16 eine Steuereinheit 72 umfasst, mittels der die nicht dargestellten Schaltelemente des Netzwechselrichters 16 in geeigneter Weise im Schaltbetrieb betrieben werden, damit die gewünschte Energiewandlungsfunktion realisiert werden kann.

Zum Zwecke der diskretisierten Erfassung der Spannungen 22, 24 wird eine Abtastrate derart hoch gewählt, dass Frequenzanteile, insbesondere in Bezug auf die Taktrate des Netzwechselrichters 16 noch zuverlässig erfasst werden können. In der Regel ist deshalb die Abtastrate der Spannungssensoreinheit 36 mindestens doppelt so hoch wie die höchste Taktrate des Netzwechselrichters 16. Unter Berücksichtigung des Abtasttheorems kann dann eine zuverlässige Erfassung auch von spektralen Anteilen aufgrund des Taktens des Netzwechselrichters 16 gewährleistet werden.

Mittels einer Fourier-Transformationseinheit 32, die vorliegend eine digitale Fourier-Transformationseinheit ist, insbesondere eine FFT, können die spektralen Komponenten 26, 28 in Bezug auf die erfassten Spannungen 22, 24 ermittelt werden. Auch wenn vorliegend eine Fourier-Transformation vorgesehen ist, kann hier eine geeignete andere Transformation genutzt werden, beispielsweise eine Laplace-Transformation oder dergleichen.

Zumindest die Anschlussspannung 22 wird mit einer so hohen Abtastrate erfasst, dass spektrale Anteile aufgrund des Taktbetriebs der Netzwechselrichters 16 zuverlässig erfasst und durch die Fourier-Transformationseinheit 32 verarbeitet werden können.

In einer alternativen Ausgestaltung kann vorgesehen sein, dass aus einem typischerweise vorhandenen, und in der Regel relativ langsam veränderlichen Spannungswert der Zwischenkreisgleichspannung am Gleichspannungszwischenkreis 48 und einer Kenntnis einer zeitlichen Signalabfolge die Anschlussspannung 22 auch mit ausreichender Genauigkeit berechnet werden kann. Ein Spannungssensor zum Erfassen der Anschlussspannung 22 kann dann eingespart werden.

Um die Funktion des Kondensators 12 ermitteln zu können, wird zumindest auch ein Induktivitätswert der Drosselspule 18 benötigt. Hierbei handelt es sich um einen bekannten Wert, der entweder extern vorgegeben sein kann oder auch mittels einer geeigneten Messeinrichtung bedarfsweise erfasst werden kann. Dies kann zum Beispiel durch ein externes Messgerät oder vorzugsweise auch in einem vorausgehenden Messverfahrensschritt mittels des Netzwechselrichters 16 selbst erfolgen.

Mittels einer Verarbeitungseinheit 30 werden die spektralen Komponenten 26, 28 sowie der Induktivitätswert der Drosselspule 18 verarbeitet, um eine frequenzabhängige Filterdämpfung beziehungsweise einen Schätzwert für einen Kapazitätswert des Kondensators 12 zu berechnen. Ein entsprechendes Verfahrensergebnis kann einer weiteren Filterüberwachung mit einer Benutzungswarnung und/oder einer Fehlerabschaltung für den Netzwechselrichter 16 zur Verfügung gestellt werden. Zu diesem Zweck ist ergänzend zur Verarbeitungseinheit 30 eine statistische Auswerteeinheit 34 vorgesehen, die den entsprechenden Schätzwert ermittelt. Hierfür kann die statistische Auswerteeinheit 34 geeignete statistische Auswertungsmethoden, insbesondere aus dem Bereich der Schätztheorie nutzen. Insbesondere besteht die Möglichkeit, den geschätzten Kapazitätswert des Kondensators 12 mit einem Kapazitätsvergleichswert zu vergleichen, um ein entsprechendes Steuersignal für die Filterüberwachung oder dergleichen bereitstellen zu können.

Bezüglich der Funktion wird insbesondere ausgenutzt, dass durch die gewählte LCL-Schaltungsstruktur die Dämpfung der Filterschaltung oberhalb einer Grenzfrequenz beinahe ausschließlich von einer Impedanz im Filterquerzweig und damit von dem Kondensator 12 abhängt. Durch diese Eigenschaft wird ermöglicht, dass eine ausreichend genaue Abschätzung des Kapazitätswerts ohne das Erfordernis einer Strommessung erreicht werden kann. Erreicht wird dies Ziel trotz unbekannter und gegebenenfalls stark veränderlicher Eigenschaften des Energieversorgungsnetzes 14 sowie etwaiger weiterer elektrischer Einrichtungen, die an dem Energieversorgungsnetz 14 angeschlossen sind.

Gemäß einer weiteren Ausgestaltung der Erfindung kann das vorbeschriebene Verfahren auch dazu genutzt werden, einen Schaltzustand des Schützes 42 zu ermitteln. Da in diesem Fall lediglich eine Ja/Nein-Entscheidung getroffen zu werden braucht, kann die Erfindung diesbezüglich auch bei starken Störungen, insbesondere stark gestörten Messwerten, großen Parameterfehlern für Bauteilwerte, beispielsweise in Bezug auf die Drosselspulen 18, 20, in Bezug auf andere Filtertopologien und/oder bei starken Störungen aus dem Wechselspannungsnetz 14, beispielsweise aufgrund von Resonanzstellen oder aktiven Störspannungsquellen oder dergleichen, zuverlässig erfolgen.

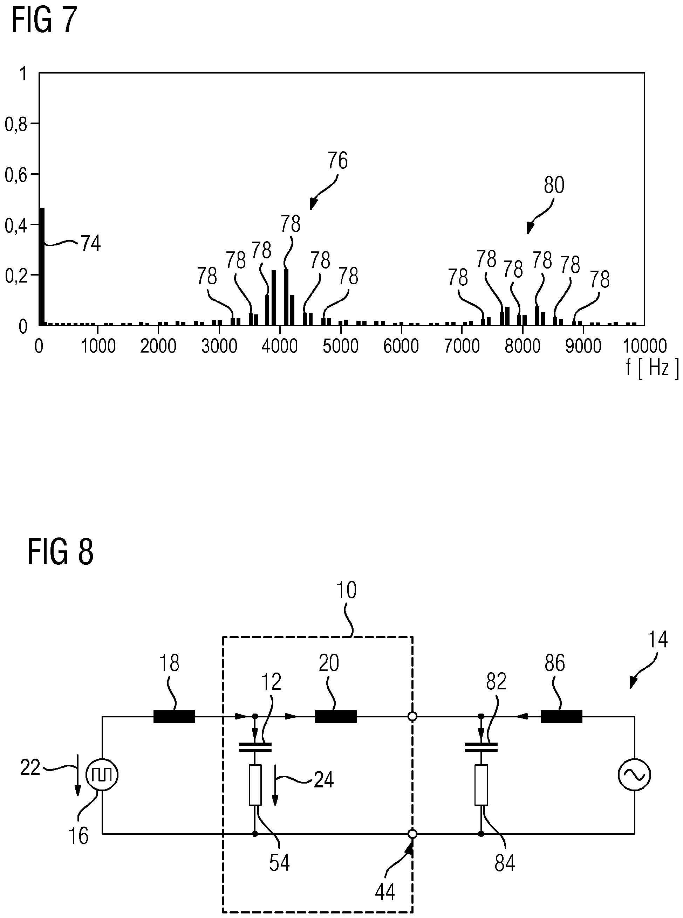

FIG 7 zeigt beispielhaft in einer schematischen Diagrammdarstellung ein Spektrum der Anschlussspannung 22 des Netzwechselrichters 16 ohne das LCL-Filter 10. Eine Abszisse des Diagramms ist der Frequenz in Hertz zugeordnet, wohingegen eine Ordinate einer relativen Störspannung zugeordnet ist.

Zu erkennen ist, dass in einem ganz linken Bereich des Diagramms mittels eines Graphen 74 eine Frequenz der Wechselspannung des Wechselspannungsnetzes 14 als Grundschwingung dargestellt ist, wie sie durch den Netzwechselrichter 16 bereitgestellt wird, und die vorliegend bei etwa 50 Hz liegt. Darüber hinaus ist zu erkennen, dass in einem Bereich 76 um eine Frequenz von etwa 4 kHz herum mehrere Amplituden spektraler Anteile mittels Graphen 78 dargestellt sind, die durch den Taktbetrieb des Netzwechselrichters 16 verursacht werden. Die Taktrate beträgt im Mittel etwa 4 kHz bei einer Modulationsart PWM. Mit zunehmendem sowie auch mit abnehmendem Abstand zu dieser Taktfrequenz von etwa 4 kHz nehmen die Amplituden der Graphen 78 im Wesentlichen ab. In einem Bereich 80 sind erneut größere Amplitudenwerte der Graphen 78 zu verzeichnen, und zwar bei einer Frequenz von etwa 8 kHz, die etwa dem Doppelten der Taktrate des Netzwechselrichters 16 entspricht.

Zu beachten ist, dass ein Ändern der Taktrate des Netzwechselrichters 16 in erster Näherung lediglich zu einer entsprechenden Verschiebung der spektralen Anteile führt, wobei die Amplitudenwerte der jeweiligen spektralen Anteile sowie auch der Grundschwingung im Wesentlichen unverändert bleiben. Im Übrigen erklärt dies auch, weshalb bei Nutzung eines LCL-Filters 10 mit einer Dämpfungscharakteristik gemäß FIG 5 mit zunehmender Taktrate Dämpfungsraten größer werden, insbesondere oberhalb einer Resonanzfrequenz des LCL-Filters 10, wie dies anhand von FIG 5 bereits erläutert wurde. Dadurch kann am Anschluss 44 eine Störaussendung in Richtung des Wechselspannungsnetzes 14 reduziert werden.

Aus FIG 5 ist ferner ersichtlich, dass eine Abhängigkeit der Dämpfung vom Kapazitätswert des Kondensators 12 besonders dann gegeben ist, wenn die Frequenz der Spannung, mit der das LCL-Filter 10 beaufschlagt wird, deutlich größer als null Hz ist. Eine solche Beaufschlagung kann mittels eines geeigneten Testsignals erreicht werden. Im Grunde nach wäre damit eine jede Anschlussspannung 22 mit einem Signalanteil mit genügend großer Frequenz als Testsignal möglich. Ein separates Testsignal braucht jedoch nicht vorgesehen zu sein, zumal dies selbst zu einer zusätzlichen Störaussendung in das Wechselspannungsnetz 14 führen könnte und gegebenenfalls auch zusätzliche Verluste im Netzwechselrichter 16 sowie auch im LCL-Filter 10 bewirken könnte. Stattdessen wird ausschließlich als Testsignal die Anschlussspannung 22 des Netzwechselrichters 16 genutzt, wie es anhand von FIG 7 dargestellt ist. Es ist also kein separates zusätzliches Testsignal erforderlich.

Durch schnelles Wechseln zwischen zwei oder mehreren unterschiedlichen Spannungsniveaus kann der Netzwechselrichter 16 im zeitlichen Mittel einen nahezu kontinuierlichen Spannungsverlauf erzeugen. Das schnelle Wechseln zwischen den Spannungspegeln erfolgt bevorzugt unter Nutzung einer PWM-Modulation. Dem Grunde nach sind jedoch auch andere Modulationsverfahren entsprechend anwendbar. Im Übrigen kann auch ein Frequenzwobbeln genutzt werden, also eine fortlaufende Variation der Taktrate des Netzwechselrichters 16.

Zu beachten ist, dass die Kondensatorspannung 24 sowie gegebenenfalls auch die Anschlussspannung 22 zeitlich entsprechend aufgelöst erfasst werden, sodass spektrale Anteile der Anschlussspannung 22 ermittelt werden können, wobei die Frequenzen dieser Spannungsanteile so hoch liegen, dass die Kondensatorspannung 24 sowie auch die Spannung am Anschluss 44 maßgeblich durch den Kapazitätswert des Kondensators 12 bestimmt werden können. Zu beachten ist hierbei das Abtasttheorem nach Shannon. Eine Abtastrate sollte deshalb bezüglich der Spannungserfassung mindestens doppelt so groß sein, wie die höchste Frequenz, bis zu der eine spektrale Auflösung bezüglich der erfassten Spannungen erreicht werden können soll. Ist beispielsweise ein Frequenzbereich bis zu etwa 10 kHz zu erfassen, so sollte eine Abtastperiode kleiner als 50 $\mu$s für die Erfassung der Spannungen gewählt werden.

Zudem sollte beachtet werden, dass Vielfache der Taktrate ebenfalls bei den spektralen Komponenten 26, 28 auftreten können und somit eine Verletzung des Abtasttheorems vorliegen kann, wenn die Abtastrate nicht sehr hoch ist. Es können dann Spiegelfrequenzen in Bezug auf die Messwerte auftreten, die das Messergebnis insgesamt verfälschen können. Vor einer Abtastung sollte daher zusätzlich noch ein vorliegend nicht dargestelltes Anti-Aliasing-Filter zur Bandbegrenzung des zu digitalisierenden Signals vorgesehen sein. Eine bevorzugte Ausführung ist eine integrierende Messung mit einem sogenannten Sigma-Delta-Wandler über eine Taktperiode der PWM-Modulation.

Messgrößen in Bezug auf die Kondensatorspannung 24 sind im Fall eines Dreiphasen-Wechselspannungsnetzes 14 die einzelnen Phasenspannungen 40, und zwar gegenüber dem Bezugspotential 38. Dabei kann vorgesehen sein, dass wenigstens zwei Phasen erfasst werden und die Kondensatorspannung 24 für eine dritte Phase aus einer Nullsummenbedingung berechnet wird, oder mindestens zwei Spannungen zwischen den Phasen erfasst werden und aufgrund einer Nullsummenbedingung die dritte entsprechende Spannung berechnet wird. Bei einem Vier-Leiter-System mit einem Nullleiteranschluss ist entsprechend jeweils eine Größe mehr zu messen, dagegen bei einem Zwei-Leiter-System jeweils eine Größe weniger.

In Bezug auf die FIG 2 bis 4 ist ferner anzumerken, dass die unterschiedlichen Filterstrukturen sich in ihren Bauteilekosten und Frequenzgängen unterscheiden und dementsprechend abhängig vom Wechselrichtertyp, einer Taktrate oder einem Modulationsverfahren ausgewählt werden können. Eine passive Dämpfung mittels des elektrischen Widerstands 54 kann eine Resonanzüberhöhung, wie sie im Folgenden noch erläutert werden wird, reduzieren. Eine Verdrosselung mittels der Drosselspule 52 kann neue dynamische Eigenschaften bereitstellen und zum Beispiel ein Minimum im Frequenzgang erzeugen, wodurch eine reduzierte Dämpfung oberhalb einer entsprechenden Auslegungsfrequenz beziehungsweise Grenzfrequenz erreicht werden kann. Bei der Schaltungsstruktur gemäß FIG 4 wird ferner davon ausgegangen, dass die netzseitige Drosselspule 20 entfallen kann, weil das Energieversorgungsnetz 14 eine geeignete minimale Induktivität bereitstellt.

Insgesamt ist festzustellen, dass die Filterwirkung beziehungsweise die Filterdämpfung der Filterschaltung in einem geeignet gewählten Frequenzbereich vorrangig von dem Kapazitätswert des Kondensators 12 und dem Induktivitätswert der Drosselspule 18 abhängig ist. Der Frequenzbereich wird dabei vorzugsweise derart gewählt, dass eine möglichst eindeutige Abhängigkeit gegeben ist und die Anschlussspannung 22 einen ausreichend großen Spannungsanteil in diesem Frequenzbereich enthält. Bevorzugt wird das vorgeschlagene Verfahren auf LCL-Filter mit einem kleinen oder ohne Dämpfungswiderstand 54 angewendet.

Grundsätzlich ist die Erfindung natürlich nicht nur auf eine Anwendung bei einer Filterschaltung zwischen einem Netzwechselrichter und einem Energieversorgungsnetz begrenzt, sondern sie kann gleichermaßen auch zwischen einem Maschinenwechselrichter und einer daran angeschlossenen elektrischen Maschine angewendet werden. In diesem Fall ist die elektrische Maschine wie das Energieversorgungsnetz 14 zu behandeln. Ziel kann hier dann sein, dass die elektrische Maschine geschützt wird, die bei einer Reduzierung des Kapazitätswerts des Kondensators 12 beschädigt werden könnte, sodass ein großer Schaden entstehen könnte.

Im Folgenden wird die Realisierbarkeit beispielhaft dargestellt und Eigenschaften sowie eine erreichbare Messgenauigkeit an Beispielen abgeschätzt.

Zu diesem Zweck wird von einem schematischen Ersatzschaltbild gemäß FIG 8 ausgegangen, welches auf der Filterschaltung gemäß FIG 2 basiert. Das Ersatzschaltbild stellt den Netzwechselrichter 16 vereinfacht dar. Der Gleichspannungszwischenkreis 48 sowie etwaige, daran angeschlossene elektrische Einheiten sind der Übersichtlichkeit halber nicht dargestellt.

Der Netzwechselrichter 16 stellt die Anschlussspannung 22 bereit, weshalb der Netzwechselrichter 16 im Ersatzschaltbild gemäß FIG 8 lediglich als Spannungsquelle dargestellt ist. Das Ersatzschaltbild gemäß FIG 8 stellt ferner lediglich eine einzelne Phase des dreiphasigen Wechselspannungsnetzes 14 dar. Für die beiden anderen Phasen des dreiphasigen Wechselspannungsnetzes 14 gelten die gleichen Überlegungen.

Das Ersatzschaltbild gemäß FIG 8 stellt eine Näherung des dreiphasigen Gesamtsystems dar, die insbesondere die impulsfrequenten Schalthandlungen bei der Realisierung des Schaltbetriebs des Netzwechselrichters 16 zwischen den Spannungspegeln wechselrichterseitig nachbildet. Mit Hilfe der Drosselspule 18, die eine Kommutierungsdrossel darstellt, und dem Filterquerzweig mit dem Kondensator 12 sowie einem Widerstand 54 können die schaltfrequenten Anteile aufgrund des Schaltbetriebs in der Anschlussspannung 22 bereits stark reduziert werden. Die Größe der Filterdämpfung ist anhand des Filter-Frequenzgangs bestimmt, wie er anhand der folgenden Formel ermittelt werden kann:

$$|H_{UFW}(j\omega)| = |\frac{U_F(j\omega)}{U_W(j\omega)}|$$

$U_F$ entspricht dabei der spektralen Komponente 26, die der Kondensatorspannung 24 zugeordnet ist, und $U_W$ entspricht dabei der spektralen Komponente 28, die der Anschlussspannung 22 zugeordnet ist.

Mit der Drosselspule 20 kann die Filterwirkung weiter verbessert werden und ein definierter Mindestinduktivitätswert zwischen dem Anschluss 44 und dem Kondensator 12 erreicht werden.

Netzseitig befinden sich typisch benachbarte Komponenten, die zum Beispiel kapazitive Eingangsfilter aufweisen können, beispielsweise ein EMV-Filter mit einem Kondensator 82 sowie einem Widerstand 84 sowie weitere induktive Komponenten oder Übertragungsglieder zu einer entfernten Spannungsquelle 88 des Energieversorgungsnetzes 14, die im Ersatzschaltbild mit der Drosselspule 86 integral erfasst sind.

Für eine Laplace-Übertragungsfunktion H zur spektralen Analyse mit einer komplexen Variable s findet sich zum Beispiel der folgende Zusammenhang:

$$H_{UFW}(s) = \frac{U_F(s)}{U_W(s)}$$

$$= \frac{s^4 L_2 L_N C_F C_E R_F + s^3 (L_2 L_N C_E + C_F C_E R_F R_E L_{2N}) + s^2 L_{2N}(C_F R_F + C_E R_E) + s L_{2N}}{s^5 a_5 + s^4 a_4 + s^3 a_3 + s^2 a_2 + s^1 a_1 + a_0}$$

mit

$$L_{2N} = L_2 + L_N;$$

$$a_5 = L_1 L_2 L_N C_F C_E;$$

$$a_4 = L_2 L_N C_F C_E R_F + L_1 C_F C_E R_E L_{2N} + L_1 L_N C_F C_E R_F;;$$

$$a_3 = L_1 L_N C_E + L_1 C_F C_E R_F R_E + L_2 L_N C_E + L_{2N} C_F C_E R_F R_E + L_1 L_{2N} C_F;$$

$$a_2 = L_1 C_E R_E + L_1 C_F R_F + L_{2N} C_F R_F + L_{2N} C_E R_E;$$

$$a_1 = L_1 + L_2 + L_N;$$

$$a_0 = 0;$$

$C_F$ ist dem Kondensator 12, $R_F$ ist dem Widerstand 54, $L_1$ ist der Drosselspule 18, $L_2$ ist der Drosselspule 20, $L_N$ ist der Drosselspule 86, $R_E$ ist dem Widerstand 84 und $C_E$ ist dem Kondensator 82 zugeordnet. Ohne den netzseitigen Zweig mit dem Kondensator 82 und dem Widerstand 84, der eine zusätzliche Resonanzstelle bewirken würde, vereinfacht sich das Übertragungsverhalten zu

$$H_{UFW1}(s) = H_{UFW}(s)|_{CE=0,RE\to\infty} = \frac{sC_F R_F + 1}{s^2 L_1 C_F + sC_F R_F \left(\frac{L_1}{L_{2N}} + 1\right) + \left(\frac{L_1}{L_{2N}} + 1\right)}$$

Zu beachten für die Funktionsfähigkeit der hier vorgeschlagenen Ermittlung der Funktionalität sind nun die insbesondere Abhängigkeiten in den typischen Arbeits- und Wertebereichen der Systemparameter.

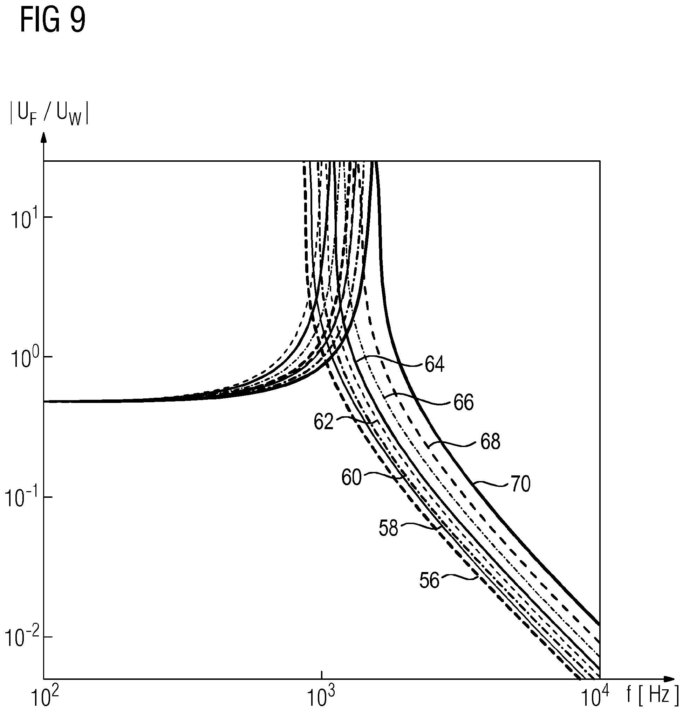

Anhand der folgenden FIG 9 bis 13 wird dies weiter erläutert. In diesen FIG ist die Abszisse jeweils der Frequenz in Hertz und die Ordinate einem relativen Verhältnis der spektralen Komponenten 26, 28 zugeordnet.

In FIG 9 sind mittels der Graphen 56 bis 70 wieder Dämpfungen abhängig von Kapazitätswerten für den Kondensator 12 dargestellt. Den Graphen 56 bis 70 ist wieder der gleiche Kapazitätswert wie zur FIG 5 erläutert zugeordnet. In dieser Ausgestaltung hat die Drosselspule 18 einen Induktivitätswert von 70 µH. Der Widerstand 54 hat einen Widerstandswert von 1 mΩ. Der elektrische Widerstand 84 ist durch eine Unterbrechung realisiert, und ein serieller energieversorgungsnetzseitiger Widerstand beträgt null Ω.

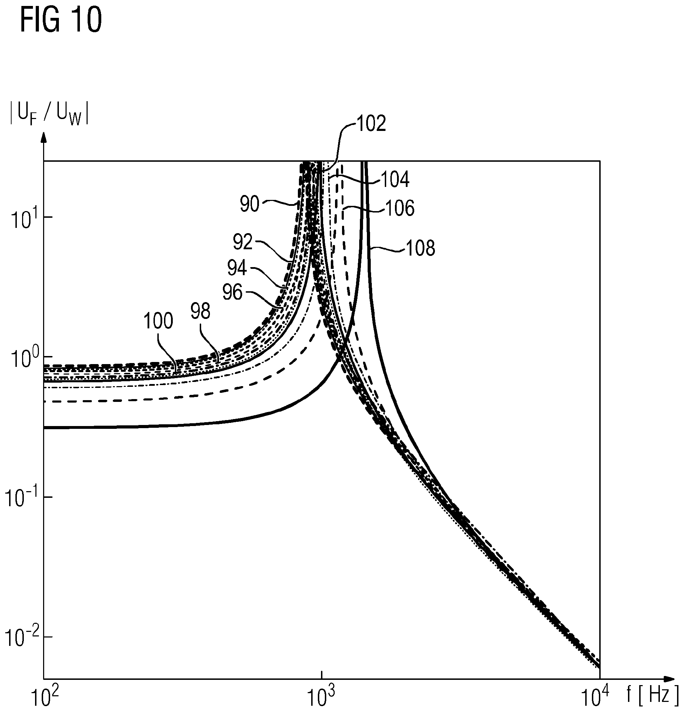

Wie aus FIG 9 ersichtlich, kann anhand der Graphen 56 bis 70 eine starke Abhängigkeit der Filterwirkung von dem Kapazitätswert des Kondensators 12 bei höheren Frequenzen erkannt werden. Dies gilt insbesondere auch für einen Arbeitsbereich oberhalb einer Resonanzstelle, die hier bei etwa 5 kHz liegt. FIG 10 zeigt eine schematische Diagrammdarstellung wie FIG 9, wobei hier jedoch der Kapazitätswert des Kondensators 12 vorliegend 600 µF beträgt. Mit den Graphen 90 bis 108 sind die Dämpfungswerte für unterschiedliche Induktivitätswerte der Summen der Induktivitätswerte der Drosselspule 20 mit der Drosselspule 86 dargestellt. Der Graph 90 entspricht dabei einem Induktivitätswert von 300 µH, der Graph 92 einem Induktivitätswert von 270 µH, der Graph 94 einem Induktivitätswert von 240 µH, der Graph 96 einem Induktivitätswert von 210 µH, der Graph 98 einem Induktivitätswert von 180 µH, der Graph 100 einem Induktivitätswert von 150 µH, der Graph 102 einem Induktivitätswert von 120 µH, der Graph 104 einem Induktivitätswert von 90 µH, der Graph 106 einem Induktivitätswert von 60 µH und der Graph 108 einem Induktivitätswert von 30 µH. Die Drosselspule 18 weist hier einen Induktivitätswert von 70 µH auf. Der Widerstand 54 hat einen Widerstandswert von 1 mΩ. Die netzseitige Impedanz wird als null angenommen und der Widerstand 84 ist durch eine Unterbrechung realisiert.

Aus FIG 10 ist ersichtlich, dass bei höheren Frequenzen nahezu keine Abhängigkeit von der Netzinduktivität, gekennzeichnet durch die Drosselspule 86, besteht, die gerade beim Betrieb des Netzwechselrichters 16 stark variieren kann. Gleiches gilt im Übrigen auch für den ohmschen Anteil einer nicht dargestellten Netzimpedanz. Dabei ist zu beachten, dass die wirksame Netzinduktivität eine Kurzschlussleistung des Energieversorgungsnetzes 14 am Anschluss 44 bestimmt und typischerweise auch von einer Bemessungsleistung des Anschlusses 44 abhängig sein kann.

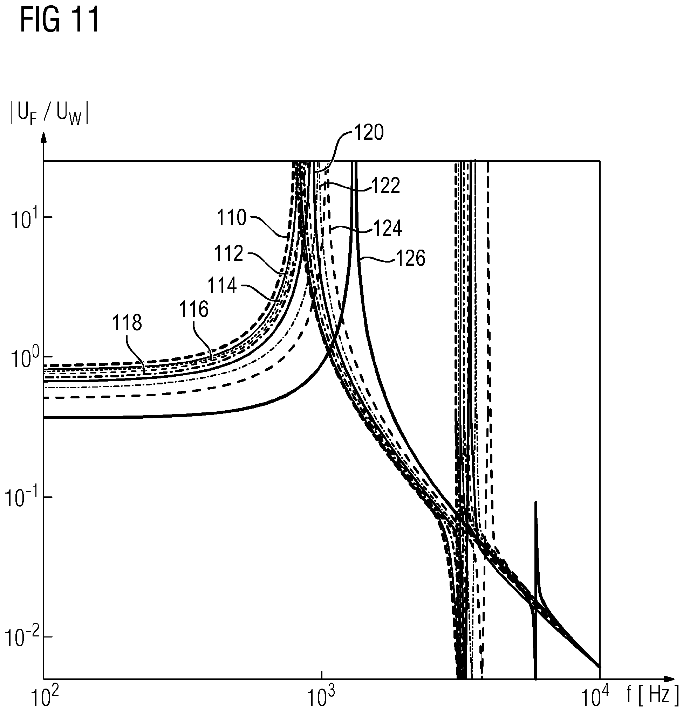

FIG 11 zeigt in einem schematischen Diagramm wie FIG 10, dass eine in der Nähe des Netzwechselrichters 16 eingebrachte, ungedämpfte Kapazität, zum Beispiel ein Kondensator eines Fremdfilters, eine zusätzliche Resonanzstelle im Bereich der Taktrate des Netzwechselrichters 16 einbringen könnte, die eine Überwachung der eigenen Filterkapazität, nämlich des Kondensators 12, stark stören könnte. Dies ist durch den Kondensator 82 sowie den Widerstand 84 realisiert.

In FIG 11 weist die Drosselspule 18 wieder einen Induktivitätswert von 70 µH auf, wohingegen die Drosselspule 20 einen Induktivitätswert von 30 µH aufweist. Der Kondensator 12 weist einen Kapazitätswert von 600 µF auf, und der Widerstand 54 weist wieder einen elektrischen Widerstandswert von 1 mΩ auf. Der Widerstand 84 ist durch einen Kurzschluss gebildet. Ein Kapazitätswert des Kondensators 82 beträgt vorliegend 100 nF.

Mittels Graphen 110 bis 126 sind Dämpfungen für unterschiedliche Induktivitätswerte der Netzinduktivität beziehungsweise der Drosselspule 86 dargestellt. Der Graph 110 ist einem Induktivitätswert von 290 µH zugeordnet. Der Graph 112 ist einem Kapazitätswert von 255 µH zugeordnet. Der Graph 114 ist einem Induktivitätswert von 220 µH zugeordnet. Der Graph 116 ist einem Induktivitätswert von 185 µH zugeordnet. Der Graph 118 ist einem Kapazitätswert von 150 µH zugeordnet. Der Graph 120 ist einem Kapazitätswert von 115 µH zugeordnet. Der Graph 122 ist einem Induktivitätswert von 80 µH zugeordnet. Der Graph 124 ist einem Induktivitätswert von 45 µH zugeordnet und der Graph 126 ist einem Induktivitätswert von 10 µH zugeordnet.

Wie aus FIG 11 ersichtlich ist, kann eine derartige ungedämpfte Kapazität, wie vorliegend durch den Kondensator 82 bewirkt, das Ermitteln der Funktion des Kondensators 12 behindern. In der Regel muss eine derartig ungedämpfte Kapazität, wie sie durch den Kondensator 82 bereitgestellt wird, jedoch bereits deshalb vermieden werden, weil somit auch ein regulärer Betrieb des Netzwechselrichters 16 starke Störungen im Netz verursachen könnte. Darüber hinaus würde eine derartige Gerätekonfiguration mit ungedämpften Kondensatoren am Wechselspannungsnetz 14 Netzrichtlinien verletzen und ist daher in der Regel nicht zulässig beziehungsweise braucht nicht als gegeben angenommen zu werden.

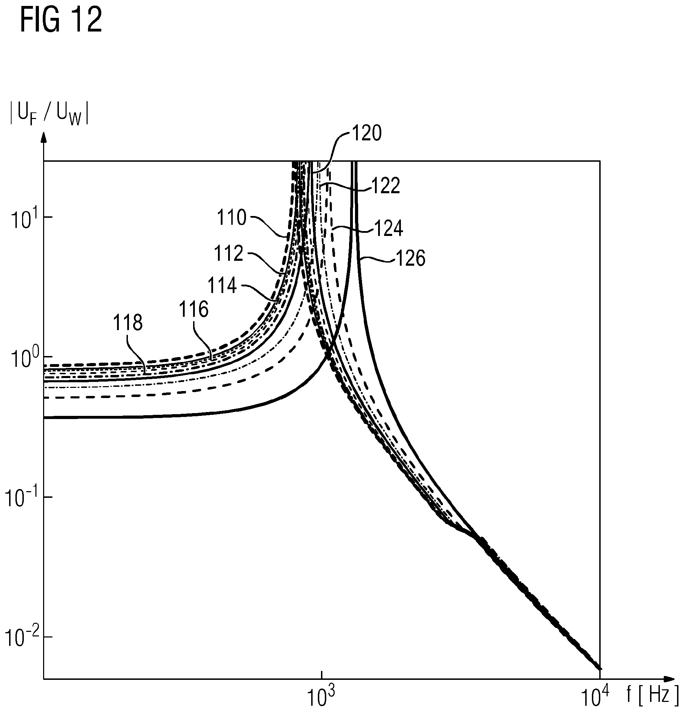

FIG 12 zeigt in einer Darstellung wie FIG 11, wie sich eine Dämpfung bezüglich des Kondensators 82 auswirkt. Im Unterschied gemäß der Darstellung gemäß FIG 11 ist bei der Darstellung gemäß FIG 12 vorgesehen, dass der Widerstand 84 nunmehr nicht durch einen Kurzschluss gebildet ist, sondern einen Widerstandswert von 0,2 Ω aufweist. Wie FIG 12 zeigt, führt diese Dämpfung wiederum zu einer Entkopplung des eigenen LCL-Filters 10 von den Netzparametern bei höheren Frequenzen, sodass die erfindungsgemäße Ermittlung der Funktion des Kondensators 12 deutlich verbessert möglich ist.

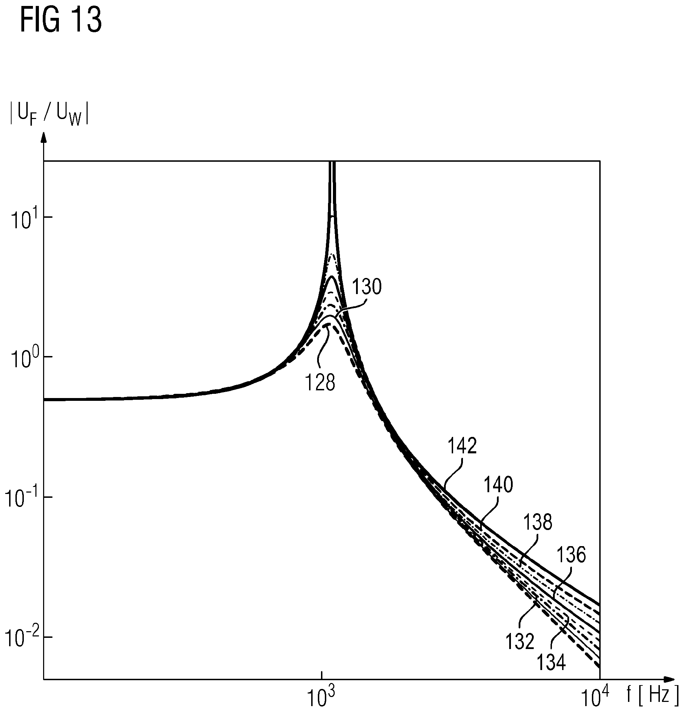

FIG 13 zeigt eine weitere schematische Diagrammdarstellung wie die vorhergehenden Diagrammdarstellungen gemäß der FIG 9 bis 12, wobei hier jedoch die Auswirkung des elektrischen Widerstands 54 aufgezeigt werden sollen. Die Parameter sind dem Grunde nach wie zur FIG 9 erläutert gewählt, wobei für den Kondensator 12 ein Kapazitätswert von 600 µF gesetzt ist. Mittels Graphen 128 bis 142 sind die Dämpfungswerte für unterschiedliche Widerstandswerte des Widerstands 54 dargestellt. Dabei entspricht der Graph 128 einem Widerstandswert von 71 mΩ, der Graph 130 einem Widerstandswert von 61 mΩ, der Graph 132 einem Widerstandswert von 51 mΩ, der Graph 134 einem Widerstandswert von 41 mΩ, der Graph 136 einem Widerstandswert von 31 mΩ, der Graph 138 einem Widerstandswert von 21 mΩ, der Graph 140 einem Widerstandswert von 11 mΩ und der Graph 142 einem Widerstandswert von 1 mΩ.

Wie aus FIG 13 ersichtlich ist, ist der Widerstandswert bei der Ermittlung der Funktion des Kondensators 12 möglicherweise nicht immer vernachlässigbar, jedoch ist er bekannt und schwankt nur geringfügig, sodass er bedarfsweise entsprechend berücksichtigt werden kann.

Unter Berücksichtigung der oben genannten Laplace-Transformation ergibt sich für genügend große Werte von s ein bei üblichen Filterentwürfen genügend kleines Verhältnis

$$\frac{L_1}{L_{2N}} < \frac{L_1}{L_2}$$

wobei $L_1$ der Drosselspule 18 und $L_2$ der Drosselspule 20 zugeordnet ist. Unter der Annahme eines gegen null strebenden Dämpfungswiderstands ergibt sich eine einfache Näherung für die Dämpfung H:

$$H_{UFW1}(s) \approx \frac{1}{s^2 L_1 C_F}$$

Das heißt, man kann einen Schätzwert $\tilde{C}_F$ für den Kapazitätswert des Kondensators 12 mit Hilfe der spektralen Komponenten 26, 28, die den spektralen Spannungsamplituden $|U_F(f_a)|$ und $|U_W(f_a)|$ entsprechen, bei einer genügend hohen Mess- beziehungsweise Schaltfrequenz $f_a$ ermitteln:

$$\tilde{C}_F = \frac{|U_F(f_a)|}{|U_W(f_a)|} \frac{1}{2\pi f_a L_1}$$

Um die Messgenauigkeit zu verbessern, können mehrere Frequenzlinien oder ein ganzer Frequenzbereich in die Messung einbezogen werden. Der Schätzwert kann sich dann beispielsweise durch Mittelwertbildung von mehreren Einzelmessungen, wie bereits oben beschrieben, oder auch durch eine Optimierung mittels einer quadratischen Minimierung eines Schätzfehlers ergeben. Denkbar ist auch, die Mittelwertbildung bereits im Frequenzbereich beziehungsweise im Spektralbereich vorzunehmen. Beispielsweise können dazu zunächst für die spektralen Komponenten 26, 28 quadratische Summen von Einzelamplituden im Frequenzbereich beziehungsweise im Spektralbereich berechnet und anschließend die Wurzel gezogen werden. Dann kann gelten:

$$\tilde{C}_F = \frac{\sqrt{U_F^2(f_n) + U_F^2(f_{n+1}) + \cdots + U_F^2(f_k)}}{\sqrt{U_W^2(f_n) + U_W^2(f_{n+1}) + \cdots + U_W^2(f_k)}} \frac{1}{2\pi \tilde{f}_a L_1}$$

mit dem Frequenzmittelwert

$$\tilde{f}_a = \frac{\sum_n^k f_i}{k - n + 1}$$

in dem betrachteten Frequenzbereich mit äquidistanten Einzelamplituden bei $f_n = n f_{Basis}$ bis $f_k = k\, f_{Basis}$ und $n < k$.

Eine Mittelwertbildung im Frequenzbereich ist insbesondere dann empfehlenswert, wenn im Fall eines so genannten Wobbelns die Taktrate beim Netzwechselrichter 16 nahezu fortlaufend geändert wird und somit im Gegensatz zu FIG 7 keine separaten Einzelamplituden im Spektrum erkennbar sind.

Die Schaltfrequenz und damit die Messfrequenz können gezielt verändert werden, um den Einfluss externer Störgrößen zu minimieren. Die Messung kann zeitlich synchronisiert mit der Veränderung der Schaltfrequenz beziehungsweise der Taktrate erfolgen. Die Änderung der Frequenzanteile der Anschlussspannung 22 bei einer zweiten Schaltfrequenz sind dann mit großer Wahrscheinlichkeit dem Netzwechselrichter 16 und der Wirkung des LCL-Filters 10 zuzuordnen.

Für die Berechnung des Schätzwerts $\tilde{C}_F$, werden dann nicht die absoluten Spannungen, sondern Spannungsänderungen aufgrund des Wechsels der Taktrate genutzt. Dann gilt

$$\tilde{C}_F = \frac{|\Delta U_F(f_a)|}{|\Delta U_W(f_a)|} \frac{1}{2\pi f_a L_1}$$

Ist der Widerstandswert des Widerstands 54 deutlich größer als null, so sollte dieser bei der Auswertung berücksichtigt werden. In diesem Fall sind bevorzugt nummerische Lösungsverfahren für Gleichungssysteme zu nutzen. Zudem sollte in diesem Fall nicht nur das Betragsspektrum der Spannungen 22, 24 ausgewertet werden, sondern auch entsprechende Phasenwinkel berücksichtigt werden.

Alternativ kann für diesen Fall auch vorgesehen sein, aus bekannten Gerätedaten des Netzwechselrichters 16 oder durch einmalige Referenzmessungen, beispielsweise bei einer Inbetriebnahme, einer Wartung oder dergleichen, einen Referenzwert oder eine Referenzkurve für einen Frequenzgang

$$\frac{U_F(f)}{U_W(f)}$$

des Netzfilters zu ermitteln und einen zulässigen Toleranzbereich beziehungsweise Überwachungsbereich für die Filterwirkung zu definieren. Bei Verletzung des Toleranzbereichs kann dann beispielsweise eine Warnung, eine Abschaltung zum Beispiel des Netzwechselrichters 16 oder dergleichen erfolgen.

Um eine sofortige Abschaltung zu vermeiden, könnte auch vorgesehen sein, die Taktrate des Netzwechselrichters 16 derart zu erhöhen, dass trotz des zu kleinen Kapazitätswerts des Kondensators 12 noch eine ausreichende Dämpfungswirkung durch das LCL-Filter 10 erreicht werden kann.

Wie aus FIG 11 ersichtlich, kann das Überwachungssystem für den Kondensator 12 auch dazu genutzt werden, um unzulässige Änderungen im Bereich des Energieversorgungsnetzes 14 zu erkennen. Dies könnte zum Beispiel durch einen Einbau eines ungeeigneten Filters in einem benachbart angeschlossenen Verbraucher sein, eine Fehlfunktion in einem benachbart angeschlossenen Gerät, eine Entstehung kritischer Resonanzstellen im Energieversorgungsnetz 14 durch Schaltvorgänge im Netz beziehungsweise Netzausfälle oder dergleichen.

Eine Alarmmeldung beziehungsweise eine Reaktion des Netzwechselrichters 16, die im Fall eines als unzulässig erkannten Kapazitätswerts des Kondensators 12 ausgegeben werden kann, kann explizit auch auf mögliche äußere Ursachen hinweisen. Gegebenenfalls können dann zusätzliche Maßnahmen beziehungsweise Messungen zum Auffinden von einem externen Fehler eingesetzt werden. Mit Hilfe der vorgenannten Variation der Taktrate und der Abtastrate kann jedoch in der Regel eine eindeutige Unterscheidung zwischen einer Änderung des Kapazitätswerts des Kondensators 12 oder einem externen Einfluss getroffen werden. Die Taktrate und/oder die Abtastrate brauchen also für die Erfindung grundsätzlich nicht konstant gewählt zu sein. Sie können gegebenenfalls auch in geeigneter Weise während der erfindungsgemäßen Verfahrensführung angepasst beziehungsweise geändert werden.

Eine externe Ursache, wie zum Beispiel ein extern ergänzend angeschlossener Filter mit einer defekten Dämpfung, kann in aller Regel nur in einem relativ schmalen Frequenzbereich zu Spannungsüberhöhungen führen. Bei höheren und niedrigeren Messfrequenzen beziehungsweise Taktraten kann dahingegen weiterhin ein sinnvoller Schätzwert $\tilde{C}_F$ ermittelt werden.

Die Erfindung ermöglicht es also, materialaufwendige und fertigungsaufwendige Messungen in Bezug auf einen Strom eines Filterkondensators wie dem Kondensator 12 zu vermeiden. Mit der Erfindung wird als Messeinrichtung eine Kondensatorspannungsmessung für den Kondensator 12 benötigt, die häufig ohne dies bereits bei elektrischen Einrichtungen der gattungsgemäßen Art, insbesondere Netzwechselrichtern enthalten ist. Damit kann die Funktion des Kondensators im Wesentlichen ohne zusätzliche Kosten für Material und Fertigung realisiert werden. Die Anschlussspannung 22 ist in der Regel ebenfalls einrichtungsseitig bereits verfügbar, sodass auch diesbezüglich keine ergänzenden Aufwendungen erforderlich zu sein brauchen.

Die Erfindung ermöglicht es also, die Funktion des Kondensators einer passiven Filterschaltung zu ermitteln, und damit diese auch zu überwachen. Dabei wird die Erkenntnis genutzt, dass bei hohen Frequenzen die Spannung über dem Kondensator 12 maßgeblich von dem Kapazitätswert des Kondensators 12 bestimmt wird und in weiten Bereichen unabhängig von unbekannten äußeren Einflüssen, insbesondere durch das Energieversorgungsnetz 14 ist. Ein Verhältnis der spektralen Komponenten 26, 28 kann daher in einem geeignet hohen Frequenzbereich als gutes Maß für das Schätzen des Kapazitätswerts des Kondensators 12 genutzt werden. Dabei ist es ferner anzuraten, zum Erfassen der Spannungen ausreichend hohe Abtastraten zu nutzen und vorzugsweise Aliasing-Effekte durch höherfrequente Störungen zu unterdrücken. Für die Bewertung der Kapazität des Kondensators 12 sind keine gesonderten Testsignale erforderlich.

Die vorgenannten Ausführungsbeispiele dienen ausschließlich der Erläuterung der Erfindung und sollen diese nicht beschränken.

**Patentansprüche**

1. Verfahren zum Ermitteln einer Funktion eines Kondensators (12) einer passiven Filterschaltung (10), die leitungsgebundene Störungen einer mit einem Energieversorgungsnetz (14) über die Filterschaltung (10) elektrisch gekoppelten elektrischen Einrichtung (16) zumindest teilweise reduziert, zu welchem Zweck die Filterschaltung (10) wenigstens den einen Kondensator (12) mit einem vorgegebenen Kapazitätswert und wenigstens eine Drosselspule (18, 20) mit einem vorgegebenen Induktivitätswert umfasst, wobei eine Anschlussspannung (22) der elektrischen Einrichtung (16) erfasst wird, wobei

   - eine elektrische Kondensatorspannung (24) an dem wenigstens einen Kondensator (12) zumindest mittelbar erfasst wird,

- für die Kondensatorspannung (24) und die Anschlussspannung (22) jeweilige spektrale Komponenten (26, 28) ermittelt werden und
- die Funktion des wenigstens einen Kondensators (12) ermittelt wird, indem die spektralen Komponenten (26, 28) bezüglich der Kondensatorspannung (24) und der Anschlussspannung (22) unter Berücksichtigung des Induktivitätswerts der wenigstens einen Drosselspule (18) mittels wenigstens einer statistischen Verarbeitung ausgewertet werden, indem eine frequenzabhängige Dämpfung der passiven Filterschaltung (10) ermittelt wird, mit der ein Schätzwert für einen Kapazitätswert des wenigstens einen Kondensators (12) berechnet wird, um aus dem Schätzwert die Funktion des wenigstens einen Kondensators (12) abzuleiten,

wobei

- die frequenzabhängige Dämpfung als Filterdämpfung der passiven Filterschaltung (10) oberhalb einer Grenzfrequenz im Wesentlichen von der Impedanz des wenigstens einen Kondensators (12) abhängt,
- die frequenzabhängige Dämpfung in Abhängigkeit eines Verhältnisses der spektralen Komponente (26) der Kondensatorspannung (24) zur spektralen Komponente (28) der Anschlussspannung (22) ermittelt wird.

2. Verfahren nach Anspruch 1, **dadurch gekennzeichnet, dass** der wenigstens eine Kondensator (12) an einem seiner Anschlüsse mit einem elektrischen Bezugspotential (38) und an einem anderen seiner Anschlüsse mit einem elektrischen Phasenpotential (40) gekoppelt wird.

3. Verfahren nach Anspruch 1 oder 2, **dadurch gekennzeichnet, dass** die Anschlussspannung (22) und/oder die Kondensatorspannung (24) diskretisiert erfasst werden und das Auswerten digital erfolgt.

4. Verfahren nach einem der vorhergehenden Ansprüche, **dadurch gekennzeichnet, dass** das Auswerten ein Ermitteln eines Kapazitätswerts des wenigstens einen Kondensators (12) umfasst.

5. Verfahren nach Anspruch 4, **dadurch gekennzeichnet, dass** das das Auswerten ein Vergleichen des ermittelten Kapazitätswerts mit einem Kapazitätsvergleichswert umfasst.

6. Verfahren nach einem der vorhergehenden Ansprüche, **dadurch gekennzeichnet, dass** zum Auswerten nur ein Teil der spektralen Komponenten (26, 28) oberhalb einer durch die Filterschaltung (10) bestimmten Grenzfrequenz berücksichtigt wird.

7. Verfahren nach einem der vorhergehenden Ansprüche, **dadurch gekennzeichnet, dass** mittels des Auswertens ein Schaltzustand eines in Reihe zum wenigstens einen Kondensator (12) geschalteten Schaltelements (42) ermittelt wird.

8. Verfahren nach einem der vorhergehenden Ansprüche, **dadurch gekennzeichnet, dass** das Verfahren bei einer elektrischen Einrichtung (16) angewendet wird, die einen Wechselrichter umfasst.

9. Verfahren nach einem der vorhergehenden Ansprüche, **dadurch gekennzeichnet, dass** das Verfahren bei einer Filterschaltung (10) angewendet wird, die eine LCL-Schaltungsstruktur umfasst.

10. Verfahren nach einem der vorhergehenden Ansprüche, **dadurch gekennzeichnet, dass** das Auswerten ein Anti-Aliasing-Filtern umfasst.

11. Ermittlungseinrichtung (46) zum Ermitteln einer Funktion eines Kondensators (12) einer passiven Filterschaltung (10), die ausgebildet ist, leitungsgebundene Störungen einer mit einem Energieversorgungsnetz (14) über die Filterschaltung (10) elektrisch gekoppelten elektrischen Einrichtung (16) zumindest teilweise zu reduzieren, zu welchem Zweck die Filterschaltung (10) wenigstens den einen Kondensator (12) mit einem vorgegebenen Kapazitätswert und wenigstens eine Drosselspule (18, 20) mit einem vorgegebenen Induktivitätswert umfasst, wobei die Ermittlungseinrichtung (46) ausgebildet ist, eine Anschlussspannung (22) der elektrischen Einrichtung (16) zu erfassen, wobei die Ermittlungseinrichtung (46) ausgebildet ist,

- eine elektrische Kondensatorspannung (24) an dem wenigstens einen Kondensator zumindest mittelbar zu erfassen,
- für die Kondensatorspannung (24) und die Anschlussspannung (22) jeweilige spektrale Komponenten (26, 28) zu ermitteln, und

- die Funktion des wenigstens einen Kondensators (12) zu ermitteln, indem die Ermittlungseinrichtung (46) dazu eingerichtet ist, die spektralen Komponenten (26, 28) bezüglich der Kondensatorspannung (24) und der Anschlussspannung (22) unter Berücksichtigung des Induktivitätswerts der wenigstens einen Drosselspule (18) mittels wenigstens einer statistischen Verarbeitung auszuwerten, zu welchem Zweck die Ermittlungseinrichtung (46) dazu eingerichtet ist, eine frequenzabhängige Dämpfung der passiven Filterschaltung (10) 2-zu ermitteln, daraus einen Schätzwert für einen Kapazitätswert des wenigstens einen Kondensators (12) zu berechnen, und aus dem Schätzwert die Funktion des wenigstens einen Kondensators (12) abzuleiten,

wobei

- die frequenzabhängige Dämpfung als Filterdämpfung der passiven Filterschaltung (10) oberhalb einer Grenzfrequenz im Wesentlichen von der Impedanz des wenigstens einen Kondensators (12) abhängt,
- die Ermittlungseinrichtung dazu eingerichtet ist, die frequenzabhängige Dämpfung in Abhängigkeit eines Verhältnisses der spektralen Komponente (26) der Kondensatorspannung (24) zur spektralen Komponente (28) der Anschlussspannung (22) zu ermitteln.

12. Elektrische Einrichtung mit;

- einem Anschluss (44) zum elektrischen Koppeln mit einem Energieversorgungsnetz (14),
- einer passiven Filterschaltung (10), die an dem Anschluss (44) angeschlossen ist und über die die elektrische Einrichtung mit dem Energieversorgungsnetz (14) elektrisch koppelbar ist, wobei die passive Filterschaltung (10) ausgebildet ist, leitungsgebundene Störungen zumindest teilweise zu reduzieren, zu welchem Zweck die Filterschaltung (10) wenigstens einen Kondensator (12) mit einem vorgegebenen Kapazitätswert und wenigstens eine Drosselspule (18, 20) mit einem vorgegebenen Induktivitätswert umfasst, und
- einer Ermittlungseinrichtung (46) zum Ermitteln einer Funktion des wenigstens einen Kondensators (12) der passiven Filterschaltung (10), wobei die Ermittlungseinrichtung (46) ausgebildet ist, eine elektrische Kondensatorspannung (24) an dem wenigstens einen Kondensator (12) zumindest mittelbar zu erfassen,

**dadurch gekennzeichnet, dass**
die Ermittlungseinrichtung (46) nach Anspruch 11 ausgebildet ist.

## Claims

1. Method for determining a function of a capacitor (12) of a passive filter circuit (10), which at least partially reduces line-conducted interferences of an electrical device (16) coupled electrically to a power supply system (14) via the filter circuit (10), to which end the filter circuit (10) comprises at least the one capacitor (12) having a predefined capacitance value and at least one choke (18, 20) having a predefined inductance value, wherein a connection voltage (22) of the electrical device (16) is detected, wherein

- an electrical capacitor voltage (24) on the at least one capacitor (12) is detected at least indirectly,
- for the capacitor voltage (24) and the connection voltage (22) respective spectral components (26, 28) are determined, and
- the function of the at least one capacitor (12) is determined by the spectral components (26, 28) being evaluated with regard to the capacitor voltage (24) and the connection voltage (22) taking into consideration the inductance value of the at least one choke (18) by means of at least one statistical processing operation, in that a frequency-dependent damping of the passive filter circuit (10) is determined, with which an estimated value for a capacitance value of the at least one capacitor (12) is computed, in order to derive the function of the at least one capacitor (12) from the estimated value,

wherein

- the frequency-dependent damping as filter damping of the passive filter circuit (10) above a limit frequency essentially depends on the impedance of the at least one capacitor (12),
- the frequency-dependent damping is determined as a function of a ratio of the spectral component (26) of the capacitor voltage (24) to the spectral component (28) of the connection voltage (22).

2. Method according to claim 1, **characterised in that** the at least one capacitor (12), at one of its connections, is coupled to an electrical reference potential (38) and at another of its connections to an electrical phase potential (40) .

3. Method according to claim 1 or 2, **characterised in that** the connection voltage (22) and/or the capacitor voltage (24) is detected discretized and is evaluated digitally.

4. Method according to one of the preceding claims, **characterised in that** the evaluation comprises a determination of a capacitance value of the at least one capacitor (12).

5. Method according to claim 4, **characterised in that** the evaluation comprises a comparison of the capacitance value determined with a capacitance comparison value.

6. Method according to one of the preceding claims, **characterised in that** only a part of the spectral components (26, 28) above a limit frequency determined by the filter circuit (10) is taken into consideration for the evaluation.

7. Method according to one of the preceding claims, **characterised in that** by means of the evaluation a switching state of a switching element (42) connected in series with the at least one capacitor (12) is determined.

8. Method according to one of the preceding claims, **characterised in that** the method is applied to an electrical device (16) which comprises an inverter.

9. Method according to one of the preceding claims, **characterised in that** the method is applied for a filter circuit (10) which comprises an LCL circuit structure.

10. Method according to one of the preceding claims, **characterised in that** the evaluation comprises anti-aliasing filtering.

11. Determination device (46) for determining a function of a capacitor (12) of a passive filter circuit (10), which is embodied to reduce at least partially line-conducted interferences of an electrical device (16) coupled electrically to a power supply system (14) via the filter circuit (10), to which end the filter circuit (10) comprises at least the one capacitor (12) having a predefined capacitance value and at least one choke (18, 20) having a predefined inductance value, wherein the determination device (46) is embodied to detect a connection voltage (22) of the electrical device (16),
wherein the determination device (46) is embodied

   - to detect an electrical capacitor voltage (24) on the at least one capacitor at least indirectly,
   - to determine respective spectral components (26, 28) for the capacitor voltage (24) and the connection voltage (22), and
   - to determine the function of the at least one capacitor (12), in that the determination device (46) is configured to evaluate the spectral components (26, 28) with regard to the capacitor voltage (24) and the connection voltage (22) while taking into consideration the inductance value of the at least one choke (18) by means of at least one statistical processing operation, to which end the determination device (46) is configured to determine a frequency-dependent damping of the passive filter circuit (10), and therefrom to compute an estimated value for a capacitance value of the at least one capacitor (12), and to derive from the estimated value the function of the at least one capacitor (12),

   wherein

   - the frequency-dependent damping as filter damping of the passive filter circuit (10) above a limit frequency essentially depends on the impedance of the at least one capacitor (12),
   - the determination device is configured to determine the frequency-dependent damping as a function of a ratio of the spectral component (26) of the capacitor voltage (24) to the spectral component (28) of the connection voltage (22).

12. Electrical device with

   - a connection (44) for electrical coupling to a power supply system (14),
   - a passive filter circuit (10), which is connected to the connection (44) and is able to be coupled electrically via the electrical device to the power supply system (14), wherein the passive filter circuit (10) is embodied at least partially to reduce line-conducted interferences, to which end the filter circuit (10) comprises at least one capacitor (12) having a predefined capacitance value and at least one choke (18, 20) having a predefined inductance value, and
- a determination device (46) for determining a function of the at least one capacitor (12) of the passive filter circuit (10), wherein the determination device (46) is embodied to detect an electrical capacitor voltage (24) on the at least one capacitor (12) at least indirectly,

**characterized in that**
the determination device (46) is embodied according to claim 11.


**Revendications**

1. Procédé de détermination d'une fonction d'un condensateur (12) d'un circuit (10) filtrant passif, qui réduit au moins en partie des perturbations liées à la ligne d'un dispositif (16) électrique connecté électriquement à un réseau (14) d'alimentation en électricité par le circuit (10) filtrant, le circuit (10) filtrant comprenant à cette fin au moins le un condensateur (12) ayant une valeur de la capacité donnée à l'avance et au moins une bobine (18, 20) de self ayant une valeur de l'inductance donnée à l'avance, dans lequel on détecte une tension (22) d'alimentation du dispositif (16) électrique, dans lequel

   - on relève, au moins indirectement, une tension (24) de condensateur électrique sur le au moins un condensateur (12),
   - on détermine, pour la tension (24) du condensateur et la tension (22) d'alimentation, des composantes (26, 28) spectrales respectives et
   - on détermine la fonction du au moins un condensateur (12), en analysant au moyen d'au moins un traitement statistique les composantes (26, 28) spectrales se rapportant à la tension (24) du condensateur et à la tension (22) d'alimentation, en tenant en compte de la valeur de l'inductance de la au moins une bobine (18) de self, en déterminant un amortissement, en fonction de la fréquence, du circuit (10) filtrant passif, par lequel on calcule une valeur d'estimation d'une valeur de la capacité du au moins un condensateur (12), afin de déduire de la valeur d'estimation, la fonction du au moins un condensateur (12),

   dans lequel

   - l'amortissement en fonction de la fréquence en tant qu'amortissement de filtrage du circuit (10) filtrant passif dépend, au-dessus d'une fréquence limite, essentiellement de l'impédance du au moins un condensateur (12),
   - on détermine l'amortissement, en fonction de la fréquence, en fonction d'un rapport de la composante (26) spectrale de la tension (24) du condensateur à la composante (28) spectrale de la tension (22) d'alimentation.

2. Procédé suivant la revendication 1, **caractérisé en ce que** l'on connecte le au moins un condensateur (12) sur l'une de ses bornes à un potentiel (38) électrique de référence et sur une autre de ses bornes à un potentiel (40) électrique de phase.

3. Procédé suivant la revendication 1 ou 2, **caractérisé en ce que** l'on relève, de manière discrète, la tension (22) d'alimentation et/ou la tension (24) du condensateur et on effectue l'analyse de manière numérique.

4. Procédé suivant l'une des revendications précédentes, **caractérisé en ce que** l'analyse comprend une détermination d'une valeur de la capacité du au moins un condensateur (12).

5. Procédé suivant la revendication 4, **caractérisé en ce que** l'analyse comprend une comparaison de la valeur de la capacité, qui est déterminée, à une valeur de comparaison de capacité.

6. Procédé suivant l'une des revendications précédentes, **caractérisé en ce que**, pour l'analyse, on ne prend en compte qu'une partie des composantes (26, 28) spectrales au-dessus d'une fréquence limite définie par le circuit (10) filtrant.

7. Procédé suivant l'une des revendications précédentes, **caractérisé en ce que** l'on détermine, au moyen de l'analyse, un état de coupure d'un élément (42) de coupure monté en série avec le au moins un condensateur (12).

8. Procédé suivant l'une des revendications précédentes, **caractérisé en ce que** l'on applique le procédé dans un dispositif (16) électrique, qui comprend un onduleur.

9. Procédé suivant l'une des revendications précédentes, **caractérisé en ce que** l'on applique le procédé dans un circuit (10) filtrant, qui comprend une structure de circuit LCL.

10. Procédé suivant l'une des revendications précédentes, **caractérisé en ce que** l'analyse comprend un filtrage anti-repliement du spectre.

11. Dispositif (46) de détermination pour la détermination d'une fonction d'un condensateur (12) d'un circuit (10) filtrant passif, qui est constitué pour réduire au moins en partie des perturbations liées à la ligne d'un dispositif (16) électrique connecté électriquement à un réseau (14) d'alimentation en électricité par le circuit (10) filtrant, le circuit (10) filtrant comprenant à cette fin au moins le un condensateur (12) ayant une valeur de la capacité donnée à l'avance et au moins une bobine (18, 20) de self ayant une valeur de l'inductance donnée à l'avance, dans lequel le dispositif (46) de détermination est constitué pour relever une tension (22) d'alimentation du dispositif (16) électrique,
dans lequel le dispositif (46) de détermination est constitué,

- pour relever au moins indirectement une tension (24) électrique de condensateur sur le au moins un condensateur ,
- pour déterminer, pour la tension (24) du condensateur et la tension (22) d'alimentation, des composantes (26, 28) spectrales respectives, et
- pour déterminer la fonction du au moins un condensateur (12) par le fait que le dispositif (46) de détermination est conçu pour analyser, au moyen un traitement statistique, des composantes (26, 28) spectrales en ce qui concerne la tension (24) du condensateur à la tension (22) d'alimentation, en tenant compte de la valeur de l'inductance de la au moins une bobine (18) de self,

le dispositif (46) de détermination étant conçu à cette fin pour déterminer un amortissement en fonction de la fréquence du circuit (10) filtrant passif, pour en calculer une valeur estimée d'une valeur de la capacité du au moins un condensateur (12) et pour déduire de la valeur estimée la fonction du au moins un condensateur (12),
dans lequel

- l'amortissement, en fonction de la fréquence, en tant qu'amortissement de filtrage du circuit (10) filtrant passif dépend au-dessus d'une fréquence limite essentiellement de l'impédance du au moins un condensateur (12),
- le dispositif de détermination est conçu pour déterminer l'amortissement, en fonction de la fréquence, en fonction d'un rapport de la composante (26) spectrale de la tension (24) du condensateur à la composante (28) spectrale de la tension (22) d'alimentation.

12. Dispositif électrique comprenant :

- une borne (44) de connexion électrique à un réseau (14) d'alimentation en électricité,
- un circuit (10) filtrant passif, qui est connecté à la borne (44) et qui peut être connecté électriquement au réseau (14) d'alimentation en électricité par le dispositif électrique, dans lequel le circuit (10) filtrant passif est constitué pour réduire, au moins en partie, des perturbations liées à la ligne, le circuit (10) filtrant comprenant à cette fin au moins un condensateur (12) ayant une valeur de la capacité donnée à l'avance et au moins une bobine (18, 20) de self ayant une valeur de l'inductance donnée à l'avance, et
- un dispositif (46) de détermination pour la détermination d'une fonction du au moins un condensateur (12) du circuit (10) filtrant passif, dans lequel le dispositif (46) de détermination est constitué pour relever, au moins indirectement, une tension (24) électrique de condensateur sur le au moins un condensateur (12),

**caractérisé en ce que**
le dispositif (46) de détermination est constitué suivant la revendication 11.

FIG 1

14

86

44

20

40

18

38

12

10

16

48

# FIG 2

# FIG 3

# FIG 4

FIG 5

FIG 6

EP 3 785 358 B1

FIG 7

FIG 8

## FIG 9

FIG 10

## FIG 11

FIG 12

FIG 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3232217 A1

- US 9819255 B2